(19) Europäisches Patentamt
European Patent Office
Office européen des brevets

(11) **EP 1 686 633 B1**

(12) **EUROPEAN PATENT SPECIFICATION**

(45) Date of publication and mention of the grant of the patent:
**08.09.2010 Bulletin 2010/36**

(51) Int Cl.:
*H01L 41/083* *(2006.01)*    *H01L 41/22* *(2006.01)*
*F02M 51/00* *(2006.01)*    *F02M 51/06* *(2006.01)*
*B41J 2/045* *(2006.01)*    *B41J 2/055* *(2006.01)*
*F02D 35/00* *(2006.01)*

(21) Application number: **04792970.8**

(22) Date of filing: **26.10.2004**

(86) International application number:
**PCT/JP2004/015849**

(87) International publication number:
**WO 2005/041316 (06.05.2005 Gazette 2005/18)**

(54) **MULTILAYER PIEZOELECTRIC DEVICE**

MEHRSCHICHTIGES PIEZOELEKTRISCHES BAUELEMENT

DISPOSITIF PIEZO-ELECTRIQUE MULTICOUCHE

(84) Designated Contracting States:
**DE FR GB**

(30) Priority: **27.10.2003  JP 2003366564**
**29.10.2003  JP 2003369689**
**29.01.2004  JP 2004021948**
**21.05.2004  JP 2004152308**

(43) Date of publication of application:
**02.08.2006  Bulletin 2006/31**

(73) Proprietor: **KYOCERA CORPORATION**
**Kyoto-shi, Kyoto 612-8501 (JP)**

(72) Inventors:
• **TERAZONO, Masaki,**
**c/o KYOCERA CORPORATION**
**Kirishima-shi,**
**Kagoshima 8994396 (JP)**
• **OKAMURA, Takeshi,**
**c/o KYOCERA CORPORATION**
**Kirishima-shi,**
**Kagoshima 8994396 (JP)**
• **SAKAUE, Katsushi,**
**c/o KYOCERA CORPORATION**
**Kirishima-shi,**
**Kagoshima 8994312 (JP)**

(74) Representative: **Hoffmann, Klaus**
**Hoffmann - Eitle**
**Patent- und Rechtsanwälte**
**Arabellastrasse 4**
**D-81925 München (DE)**

(56) References cited:
JP-A- 9 270 540    JP-A- 2002 299 710
JP-A- 2003 258 328    US-A- 5 073 740
US-A- 2002 158 552    US-B1- 6 414 417

**Description**

TECHNICAL FIELD

The present invention relates to a multi-layer piezoelectric element and injection apparatus, for example, fuel injection apparatus of automobile engine, liquid injection apparatus of ink jet printer or the like or a drive unit used in precision positioning device or vibration preventing device for an optical apparatus, and to a multi-layer piezoelectric element used as a sensor element mounted in combustion pressure sensor, knocking sensor, acceleration sensor, load sensor, ultrasound sensor, pressure sensor, yaw rate sensor or the like, or used as a circuit component mounted in piezoelectric gyro, piezoelectric switch, piezoelectric transducer, piezoelectric breaker or the like.

BACKGROUND OF THE INVENTION

Multi-layer piezoelectric actuators constituted from piezoelectric layers and electrodes stacked alternately one on another have been known as an example of the multi-layer piezoelectric element. The multi-layer piezoelectric actuators can be divided into two categories: fired-at-once type and stacked type which has such a constitution as piezoelectric porcelain and internal electrode sheets are stacked one on another alternately. Due to the advantages of lower operating voltage and lower manufacturing cost, the multi-layer piezoelectric actuator of fired-at-once type has been becoming dominant. The multi-layer piezoelectric actuator of fired-at-once type is also more advantageous for the reason of smaller layer thickness and higher durability.

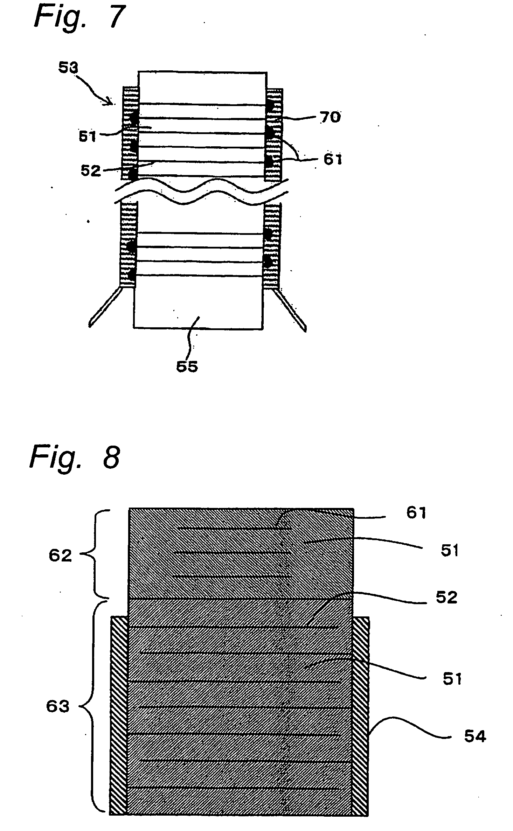

Fig. 7 is a sectional view showing an example of the multi-layer piezoelectric actuator of the prior art. This multi-layer piezoelectric actuator comprises a stacked drive section 53 formed by alternately stacking piezoelectric layers 51 and internal electrodes 52 one on another, and inactive protective sections 55 placed on both end faces of the stack in the direction of stacking. The internal electrodes 52 are formed so that an end of one of two adjacent internal electrodes 52 is exposed on the side face of the stacked drive section 53 and the other end is covered by an insulating material 61. An external electrode 70 is formed on the side face of the stacked drive section 53 where the end of the internal electrode 52 is exposed, while the other internal electrode 52 of which end is not covered by the insulating material 61 is connected to the external electrode 70.

Fig. 8 is a sectional view showing another example of the multi-layer piezoelectric element of the prior art. In this example, while piezoelectric layers 51 and the internal electrodes 52 are stacked alternately one on another, the internal electrode 52a is not formed over the entire principal surface of the piezoelectric layer 51, but is formed in a so-called partial electrode structure. The internal electrodes 52 having the partial electrode structure are stacked in a staggered manner, so that the internal electrodes 52 are connected to the external electrodes 54, which are formed on the side faces of the multi-layer electronic component, alternately in every other layer. In case the multi-layer piezoelectric element is used as a multi-layer piezoelectric actuator, lead wires (not shown) are soldered onto the external electrodes 54.

The multi-layer piezoelectric element shown in Fig. 8 is also constituted from the stacked drive section 63 formed by alternately stacking the piezoelectric layers 51 and the internal electrodes 52 one on another, and inactive protective sections 62 provided on the upper end and on the lower end of the stack in the direction of stacking. The inactive protective sections 62 ordinarily do not include electrode layer, although electrode layer similar to the stacked drive section 63 is stacked on the inactive protective sections 62 in order to prevent stress from being generated and cracks from occurring after sintering due to difference in the shrinkage between the stacked drive section 63 and the inactive protective sections 62 (refer, for example, to Patent Document 4).

The multi-layer piezoelectric element is manufactured by printing a paste used to form the internal electrode in a predetermined pattern on ceramic green sheets that would become the piezoelectric layers, stacking a plurality of the green sheets having the paste for the internal electrode printed thereon, firing the stack and baking an electrically conductive paste that would become the external electrode on the side faces (refer, for example, to Patent Document 1).

The internal electrode 52 is formed from an alloy of silver and palladium and, in order to fire the piezoelectric material 51 and the internal electrodes 52 at the same time, the composition of metals contained in the internal electrode 52 is set to 70% by weight of silver and 30% by weight of palladium (refer to, for example, Patent Document 2). However, there have been such problems that the internal electrodes made of a metal have weak strength of adhesion with the piezoelectric material, while internal stress generated by the difference in thermal expansion of both members causes cracks in the interface between the internal electrode and the piezoelectric layer and, in the worst case, the stack would break. In order to eliminate such problems, for example, Patent Document 3 describes a method of increasing the strength of adhesion between the piezoelectric layer and the internal electrode by mixing a ceramic powder in the internal electrode.

In recent years, it has been in practice to carry out continuous operation of piezoelectric actuators over a long period of time with a higher electric field applied, in order to achieve a large amount of displacement with a compact piezoelectric actuator under a high pressure.

Patent Document 1: Japanese Unexamined Patent Publication (Kokai) No. 61-133715
Patent Document 2: Japanese Unexamined Utility Model Publication (Kokai) No. 1-130568
Patent Document 3: Japanese Unexamined Patent Publication (Kokai) No. 4-299588
Patent Document 4: Japanese Unexamined Patent Publication (Kokai) No. 9-270540
Patent Document 5: US 6414417
Patent Document 6: US 2002/158552

DISCLOSURE OF THE INVENTION

PROBLEMS TO BE SOLVED BY THE INVENTION

There has been such a problem that the amount of displacement of a piezoelectric material varies as the ambient temperature becomes higher, and therefore when the device temperature becomes higher, thus the amount of displacement of a piezoelectric actuator changes. A change in the amount of displacement during operation of the actuator causes fluctuation in the load on the power source that supplies the voltage, thus placing a burden on the power source. When the amount of displacement undergoes a rapid change, not only the amount of displacement deteriorates rapidly but also the heat generated by the device exceeds the heat that can be removed by dissipation and thermal excursion occurs, thus resulting in breakage and failure.

It is effective to use an internal electrode that has lower specific resistance, in order to keep the device temperature from rising. However, the silver-palladium alloy has a specific resistance higher than that of pure silver or pure palladium, and the silver-palladium alloy having composition of 70% by weight of silver and 30% by weight of palladium shows a specific resistance 1.5 times that of pure palladium. In addition, resistance of an internal electrode made by sintering with a lower density becomes even higher.

In the multi-layer piezoelectric actuator of the prior art, there has been such a problem that the internal electrode that is softer than the piezoelectric material absorbs a part of the displacement of the piezoelectric material, thus causing the amount of displacement to vary. There has also been such a problem related to durability that the variation in the amount of displacement increases after repeated operations over a long period of time. These problems cannot be solved by the method described in Patent Document 3 of increasing the strength of adhesion between the piezoelectric material 51 and the internal electrode 52 by mixing a ceramic powder in the internal electrode 52.

In the recent practice of carrying out continuous operation over a long period of time with a higher electric field applied, in order to cause a compact piezoelectric actuator to achieve a large amount of displacement under a high pressure, there are such problems as the amount of displacement varies among the individual actuators in the early stage of use. The amount of displacement also changes with time over a long period of operation.

Furthermore, operation of the multi-layer piezoelectric actuator is based on the deformation of porcelain of the piezoelectric material under a voltage, unlike the conventional multi-layer electronic component (for example, multi-layer ceramic capacitor). That is, the porcelain of the piezoelectric material deforms the same number of times as the number of operation cycles. In recent years, it is required to carry out continuous operation over a long period of time with a higher electric field applied, in order to make a compact piezoelectric actuator capable of achieving a large amount of displacement under a high pressure.

However, the improvement described in Patent Document 4 has such a problem that continuous operation over a long period of time with a higher electric field applied thereto leads to the occurrence of cracks that disables the actuator to function, thus indicating a drawback with regards to durability.

An object of the present invention is to provide a multi-layer piezoelectric element of high reliability and high durability, that undergoes smaller variations in the amount of displacement even when used under a high electric field and high pressure and is subject to less variations in the amount of displacement even when used in continuous operation over a long period of time, and an injection apparatus.

MEANS FOR SOLVING THE PROBLEMS

First multi-layer piezoelectric element of the present invention, aimed at achieving the object described above, comprises a stack formed by stacking piezoelectric layers and internal electrodes alternately one on another and external electrodes formed on a first side face and on a second side face of the stack, wherein one of the adjacent internal electrodes is connected to the external electrode on the first side face and the other internal electrode is connected to the external electrode formed on the second side face, while the ratio of change in the amount of displacement of the element after undergoing continuous operation of $1 \times 10^9$ cycles or more to the initial device dimension is not larger than 5%, wherein the powders of the electrically conductive material and the glass are bonded with each other so as to form a porous electrical conductor having a 3-dimensional mesh configuration.

The first multi-layer piezoelectric element of the present invention that is constituted as described above does not cause malfunction of the apparatus and has excellent durability free of thermal excursion, since the amount of displacement does not substantially change after continuous operation.

Second multi-layer piezoelectric element of the present invention comprises a stack formed by stacking piezoelectric layers and internal electrodes alternately one on another and external electrodes formed on a first side face and on a second side face of the stack, wherein one of the adjacent internal electrodes is connected to the external electrode on the first side face and the other internal electrode is connected to the external electrode formed on the second side face, while the ratio of change in the resistance of the element after undergoing continuous operation of $1 \times 10^9$ cycles or more to the initial value of resistance is not larger than 5%.

The second multi-layer piezoelectric element of the present invention constituted as described above does not cause malfunction of the apparatus and has excellent durability free of thermal excursion, as the change in resistance of the element is controlled to 5% or less.

In the first and second multi-layer piezoelectric elements of the present invention, maximum change in the amount of displacement of the element during continuous operation is not larger than 5%, which enables it to prevent malfunction of the apparatus more effectively and provide excellent durability free of thermal excursion.

In the first and second multi-layer piezoelectric elements of the present invention, the ratio of change in thickness of the piezoelectric layer after undergoing continuous operation of $1 \times 10^9$ cycles or more to the thickness of the piezoelectric layer before the continuous operation is preferably not larger than 5%,.

By restricting change the in thickness of the piezoelectric layer after operation to within 5%, it is made possible to prevent malfunction of the apparatus more effectively and provide excellent durability free of thermal excursion.

In the first and second multi-layer piezoelectric elements of the present invention, maximum change in resistance of the element during continuous operation is preferably not larger than 5%.

By restricting the change in resistance of the piezoelectric layer during continuous operation to within 5%, it is made possible to prevent malfunction of the apparatus effectively and provide excellent durability free of thermal excursion.

Third multi-layer piezoelectric element of the present invention comprises a stack formed by stacking piezoelectric layers and internal electrodes alternately one on another and external electrodes formed on a first side face and on a second side face of the stack, wherein one of the adjacent internal electrodes is connected to the external electrode on the first side face and the other internal electrode is connected to the external electrode formed on the second side face, while pillars are provided to penetrate the internal electrode and connect the piezoelectric layers that oppose each other via the internal electrode.

The third multi-layer piezoelectric element of the present invention constituted as described above can minimize the variation in the amount of displacement by providing the pillars that connect the piezoelectric layers in the internal electrode. Also it is made possible to provide the piezoelectric actuator that has high reliability and improved durability and undergoes less variation in the amount of displacement after continuous operation over a long period of time. As a result, for example, an injection apparatus that is excellent in durability and has high reliability can be provided.

In the third multi-layer piezoelectric element of the present invention, it is preferable that not less than 30% of the pillars have diameter in the section thereof joined with the piezoelectric layer not smaller than 50% of the maximum diameter of the pillars.

In the third multi-layer piezoelectric element of the present invention, it is also preferable that mean value of minimum diameters of the pillars is not smaller than 0.2 $\mu$m.

In the third multi-layer piezoelectric element of the present invention, it is further preferable that the number of pillars per 1 mm is from 5 to 150.

In the third multi-layer piezoelectric element of the present invention, it is further preferable that the difference in thermal expansion coefficient between the pillar and the piezoelectric material that constitutes the piezoelectric layers is $3 \times 10^{-5}$/°C or less.

In the third multi-layer piezoelectric element of the present invention, it is also preferable that the pillars are formed from the same material as that of the piezoelectric material.

In the first through third multi-layer piezoelectric elements of the present invention that are constituted as described above, it is preferable that the stack includes inactive protective layers formed by alternately stacking the piezoelectric layers and dummy layers on the top and bottom thereof, and the ratio A/B of minimum distance A between the periphery of the dummy layer and the side face of the inactive protective layers to width B of the inactive protective layer is in a range from 0.01 to 0.08.

The minimum distance A is the length of the protective section along a plane cutting the protective section in the direction perpendicular to the direction of stacking, and width B of the inactive protective section is the length in the same direction as the minimum distance A is measured.

With the multi-layer piezoelectric element constituted as described above, it is made possible to achieve uniform shrinkage during firing and, as a proper region of junction is provided between the piezoelectric layers, stress generated between the inactive protective section and the stacked drive section can be mitigated. As a result, durability can be improved even when operated continuously under a high voltage over a long period of time, and an injection apparatus comprising the multi-layer piezoelectric element having excellent durability can be provided.

The inventor of the present application conducted a research into the minimum distance between the periphery of the dummy layer and the side face of the inactive protective layers and durability, and found a relationship between the minimum distance and durability. That is, it was found that durability can be greatly improved by controlling the minimum distance between the periphery of the dummy layer and the side face of the inactive protective layers.

In the multi-layer piezoelectric elements of the present invention that has the dummy layer, it is preferable that the dummy layer contains a metal.

It is also preferable that the dummy layer is formed from the same material as that of the internal electrode. It is also preferable that the dummy layer contains an inorganic composition, that is a metal oxide, nitride or carbide, and that the dummy layer contains 2% by weight or more of an inorganic composition.

The piezoelectric layer has thickness preferably not less than 50 $\mu$m.

In the first through third multi-layer piezoelectric elements of the present invention that are constituted as described above, it is preferable that the metal composition in the internal electrode contains group VIII metal and/or group Ib metal as the main component.

When the metal composition in the internal electrode contains group VIII metal and/or group Ib metal as the main components, the internal electrode can be formed from the metal composition that has high heat resistance and therefore can be fired together with the piezoelectric material that has a higher firing temperature at the same time.

In the first through third multi-layer piezoelectric elements of the present invention wherein the internal electrode contains group VIII metal and/or group Ib metal as the main components, it is preferable that proportion M1 (% by weight) of the group VIII metal and proportion M2 (% by weight) of the group Ib metal in the internal electrode satisfy the relations $0 < M1 \leq 15$, $85 \leq M2 < 100$ and $M1 + M2 = 100$, so that specific resistance of the internal electrode can be kept low. As a result, generation of heat from the internal electrode can be suppressed even when the multi-layer piezoelectric element is operated continuously over a long period of time. Moreover, since the temperature of the multi-layer piezoelectric element can be suppressed from increasing, the amount of displacement of the device can be stabilized.

In the multi-layer piezoelectric element of the present invention, it is preferable that the group VIII metal is at least one kind selected from among Ni, Pt, Pd, Rh, Ir, Ru and Os, and the group Ib metal is at least one kind selected from among Cu, Ag and Au. Either alloy materials or mixed powder materials may be used to form the internal electrode, as long as they are selected from those listed above.

Further, when the group VIII metal is at least one kind selected from among Pt and Pd, and the group Ib metal is at least one kind selected from among Ag and Au, the internal electrode having high heat resistance and high oxidation resistance can be formed.

Further, when the group VIII metal is Ni, stress generated by the displacement during operation can be mitigated and the internal electrode that is excellent in heat resistance can be formed.

When the group Ib metal is Cu, stress generated by the displacement during operation can be mitigated and the internal electrode that is excellent in heat conductivity can be formed.

Moreover, adhesive strength in the interface between the internal electrode and the piezoelectric material can be increased by adding oxide, nitride or carbide along with the metal composition to the internal electrode, thus suppressing peel-off from occurring in the interface between the internal electrode and the piezoelectric material.

It is preferable that the oxide described above contains perovskite type oxide consisting of $PbZrO_3$-$PbTiO_3$ as the main component.

It is further preferable that the piezoelectric layers contain perovskite type oxide as the main component.

By forming the piezoelectric material from the perovskite type oxide consisting of $PbZrO_3$-$PbTiO_3$ as the main component, it is made possible to fire the internal electrode and the piezoelectric material at the same time, thereby reducing the time required in the firing process while achieving lower specific resistance of the internal electrode.

Firing temperature of the stack is preferably in a range from 900 to 1000°C.

By controlling the deviation in the composition of the internal electrode that is caused by the firing operation within 5%, the internal electrode is enabled to deform in conformity with the expansion and contraction of the multi-layer piezoelectric element during the operation, thus making it possible to suppress the internal electrode from coming off.

In the first through third multi-layer piezoelectric elements of the present invention, it is further preferable that the internal electrode of which end is exposed on the side face of the stack and the internal electrode of which end is not exposed are stacked alternately, while a groove is formed in the piezoelectric layer located between the internal electrode of which end is not exposed and the external electrode, with the groove being filled with an insulating material that has a value of Young's modulus lower than that of the piezoelectric layer.

In the first through third multi-layer piezoelectric elements of the present invention, it is also preferable that the internal electrode includes voids and the voids occupy 5 to 70% of cross sectional area of the internal electrode. This constitution decreases the restrictive force exerted by the internal electrode on the deformation of the piezoelectric material under the effect of electric field, thereby increasing the amount of displacement of the piezoelectric material. It also provides such an advantage that stress generated in the internal electrode is mitigated by the voids, thereby improving the durability of the element. In addition, while heat transfer within the element is predominantly carried by the internal electrode, existence of the voids in the internal electrode mitigates the change in temperature within the element caused by rapid changes in the temperature outside of the element, thus making the element more resistant to thermal shock.

The injection apparatus of the present invention comprises a container having an injection hole, one of the first through third multi-layer piezoelectric elements housed in the container and a valve that allows a liquid to be ejected by the multi-layer piezoelectric element through the injection hole.

This constitution provides an injection apparatus that has high durability.

BRIEF DESCRIPTION OF THE DRAWINGS

Fig. 1A is a perspective view showing the multi-layer piezoelectric element of the present invention.

Fig. 1B is an exploded perspective view showing the piezoelectric layers and the internal electrodes being stacked in the multi-layer piezoelectric element of the present invention.

Fig. 2A is a perspective view showing the multi-layer piezoelectric element according to the second embodiment of the present invention.

Fig. 2B is a side view of the multi-layer piezoelectric element according to the second embodiment.

Fig. 3 is an enlarged sectional view of a part of the multi-layer piezoelectric element according to the second embodiment.

Fig. 4A is a perspective view showing a multi-layer piezoelectric element having an electrical conductivity assisting member formed on the outer surface of the external electrode.

Fig. 4B is a sectional view showing the multi-layer piezoelectric element having the electrical conductivity assisting member formed on the outer surface of the external electrode.

Fig. 5A is a perspective view showing the multi-layer piezoelectric element according to the third embodiment of the present invention.

Fig. 5B is a sectional view showing the piezoelectric layers, the internal electrodes, protective section and dummy layers being stacked in the multi-layer piezoelectric element of the third embodiment.

Fig. 6 is a side view showing the injection apparatus of the present invention.

Fig. 7 is a side view showing the multi-layer piezoelectric actuator of the prior art.

Fig. 8 is a sectional view showing a part of the multi-layer piezoelectric element of the prior art.

[Description of Reference Numerals]

| | |
|---|---|
| 1: | Piezoelectric material |
| 2: | Internal electrode |
| 3: | Insulating material |
| 4: | External electrode |
| 13: | Stacked drive section |
| 14, 20: | Inactive protective section |
| 18: | Pillar |
| 21: | Dummy layer |
| 22: | Junction between pillar and piezoelectric material |
| 31: | Container |
| 33: | Injection hole |
| 35: | Needle valve |
| 37: | Fuel passage |
| 39: | Cylinder |
| 41: | Piston |
| 43: | Piezoelectric actuator |

BEST MODE FOR CARRYING OUT THE INVENTION

embodiments of the present invention will now be described below with reference to the accompanying drawings.

First Embodiment

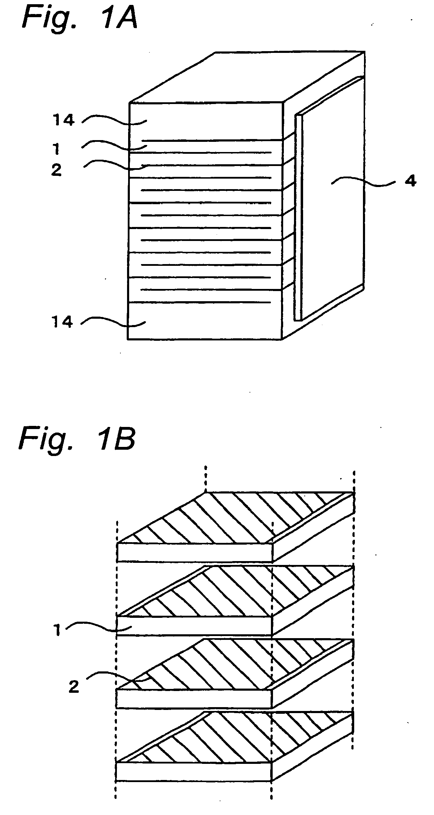

Fig. 1A is a perspective view of the multi-layer piezoelectric element according to the first embodiment of the present invention, and Fig. 1B is an exploded perspective view showing the piezoelectric layers 1 and the internal electrodes 2 being stacked one on another.

The multi-layer piezoelectric actuator of the first embodiment comprises a stack having rectangular prism shape formed by stacking a plurality of piezoelectric layers 1 and a plurality of internal electrodes 2 alternately, and external electrodes 4 formed on the side faces of the stack so as to be connected to the internal electrodes 2 in every other layer, as shown in Fig. 1A and Fig. 1B.

Specifically, an end of the internal electrode 2 is exposed on the side face whereon the external electrode 4 is formed in every other layer, so that the end of the internal electrode 2 that is exposed is electrically connected to the external electrode 4. The portion of the stack indicated with reference numeral 14 is the inactive protective section formed by stacking the piezoelectric layer 1 without internal electrodes 2 included therein. When the multi-layer piezoelectric element of the first embodiment is used as a multi-layer piezoelectric actuator, lead wires may be connected to the external electrodes 4 by soldering, with the lead wires being connected to a power source installed outside.

While the internal electrode 2 is disposed between the piezoelectric layers 1, the internal electrode 2 is used to apply a predetermined voltage to the piezoelectric layers 1, so that the piezoelectric element 1 undergoes a displacement by the reverse piezoelectric effect, and is formed from a metallic material such as silver-palladium.

The inactive protective section 14 is constituted from a plurality of piezoelectric layers 1 without the internal electrodes 2 provided. The inactive protective section 14 does not make displacement when a voltage is applied thereto.

The multi-layer piezoelectric element of the first embodiment is constituted so that the change in displacement of the element after operation is within 5% even when operated repetitively. That is, the multi-layer piezoelectric element of the first embodiment has very high durability as the change in displacement of the element after continuous operation is kept within 5%.

The ratio of change in displacement of the element after continuous operation refers to the ratio of change in displacement of the multi-layer piezoelectric element after repetitive operations to the amount of displacement before being put into continuous operation.

Specifically, after the multi-layer piezoelectric element has been made, DC voltage of a predetermined magnitude is applied to the multi-layer piezoelectric element and the amount of displacement (initial displacement) is determined before putting the multi-layer piezoelectric element into continuous operation.

Then an arbitrary AC voltage is applied to the multi-layer piezoelectric element and, after driving it to undergo about $1 \times 10^9$ cycles of operation consecutively, DC voltage of the same magnitude as that used when measuring the initial displacement is applied and the amount of displacement is determined (amount of displacement after continuous operation).

Then the ratio of the change in the amount of displacement after continuous operation to the amount of initial displacement is taken as the ratio of the change in the displacement of the element after continuous operation.

The ratio of change in the displacement of the element after continuous operation is given by the formula:

$$\{100 \times (\text{Displacement after continuous operation} - \text{Initial displacement})/(\text{Initial displacement})\}$$

Further the multi-layer piezoelectric element of the first embodiment is constituted so that maximum ratio of change in the displacement of the element during continuous operation is not larger than 5%. This is because the maximum ratio of change in the displacement of the multi-layer piezoelectric element exceeding 5% during continuous operation may cause deterioration of the multi-layer piezoelectric element during operation, thus resulting in lower durability of the multi-layer piezoelectric element.

The maximum ratio of change in the displacement of the element during continuous operation is determined as follows. The amount of displacement before continuous operation (amount of displacement in the initial state) is determined by applying a DC voltage to the multi-layer piezoelectric element. Then an AC voltage of the same magnitude as the DC voltage used when measuring the initial displacement is applied to the multi-layer piezoelectric element and the displacement is measured in every cycle during about $1 \times 10^8$ cycles of operation. The largest displacement among the measured values is taken as the maximum displacement, and the ratio of the maximum displacement to the amount of displacement before the continuous operation is determined.

While continuous operation under application of an AC voltage has been described, continuous operation may also be carried out under a pulse voltage in which case, too, the multi-layer piezoelectric element is constituted such that the maximum ratio of change in the amount of displacement during continuous operation is within 5%. For example, the amount of displacement of the multi-layer piezoelectric element under a DC voltage of 150 V is taken as the amount of displacement in the initial state. Then pulse voltage of 0 V and 150 V is applied to have the multi-layer piezoelectric element undergo about $1 \times 10^8$ cycles of continuous operation while measuring the displacement in each cycle. The element of the present invention is constituted so that the largest displacement during this continuous operation is within 5%.

The DC voltage, AC voltage and pulse voltage used when measuring the initial displacement may be set freely in a range from 100 V to 200 V.

The multi-layer piezoelectric element of the present invention is constituted such that ratio of change in thickness of the piezoelectric layer after continuous operation is not larger than 5%. This is because, when the ratio of change in thickness of the piezoelectric layer after continuous operation is larger than 5%, dimension of the multi-layer piezoelectric element itself changes, resulting in change in the amount of displacement. This accelerates the deterioration of the multi-layer piezoelectric element and results in significant decrease in durability of the multi-layer piezoelectric element.

Thickness of the piezoelectric layer can be measured by observing the piezoelectric layer in a section or side face of the multi-layer piezoelectric element under an SEM.

The ratio of change in thickness of the piezoelectric layer after operation refers to the ratio of change in thickness of the piezoelectric layer in the stacking direction, after about $1 \times 10^9$ cycles of continuous operation under an AC voltage applied to the multi-layer piezoelectric element, to the thickness of the piezoelectric layer before the continuous operation.

The ratio of change in thickness of the piezoelectric layer can be determined by observing the side face of the multi-layer piezoelectric element under an SEM before operation to measure the thickness of the piezoelectric layer at 10 points and average the measurements, while measuring the thickness of the piezoelectric layer after the continuous operation at the same points and averaging the measurements.

The multi-layer piezoelectric element of the first embodiment is constituted such that ratio of change in resistance of the multi-layer piezoelectric element after continuous operation is not larger than 5%. This is because, when the ratio of change in resistance of the multi-layer piezoelectric element after continuous operation exceeds 5%, the multi-layer piezoelectric element is subjected to more significant deterioration resulting in significantly lower durability of the multi-layer piezoelectric element.

The ratio of change in resistance of the multi-layer piezoelectric element after continuous operation is determined as follows. Resistance of the element before continuous operation is measured by applying a DC voltage to the multi-layer piezoelectric element. Then an AC voltage is applied to the multi-layer piezoelectric element and resistance of the element is measured after about $1 \times 10^9$ cycles of continuous operation. The ratio of the resistance of the element after the continuous operation to the resistance of the element before the continuous operation is taken as the ratio of change in resistance.

Further the multi-layer piezoelectric element of the first embodiment is constituted so that maximum change in resistance of the element during continuous operation is not larger than 5%. This is because maximum change in the resistance of the multi-layer piezoelectric element exceeding 5% during continuous operation may cause deterioration of the multi-layer piezoelectric element during operation, thus resulting in lower durability of the multi-layer piezoelectric element.

The maximum change in resistance of the multi-layer piezoelectric element after continuous operation is determined as follows. Resistance of the element before continuous operation is measured by applying a DC voltage to the multi-layer piezoelectric element. Then an AC voltage is applied to the multi-layer piezoelectric element and maximum resistance of the element measured during continuous operation of about $1 \times 10^8$ cycles is taken as the resistance of the element during continuous operation. The ratio of the resistance during the continuous operation to the resistance of the element before the continuous operation is taken as the maximum change in resistance.

In the multi-layer piezoelectric element of the present invention constituted as described above, the amounts of displacement of the element after continuous operation and during continuous operation, change in thickness of the piezoelectric layer after continuous operation, and changes in resistance of the element after continuous operation and during continuous operation can be controlled within 5% as follows.

For the purpose of restricting the amounts of displacement of the element, change in thickness of the piezoelectric layer and change in resistance of the element, such methods have been employed as maintaining the element temperature constant during continuous operation or minutely controlling the operating voltage in accordance to the element temperature. Specifically, the operating voltage is controlled while monitoring the element temperature, or temperature around the element is controlled by means of a heat sink installed so as to dissipate heat.

According to the first embodiment of the present invention, in contrast, the element temperature is controlled (device temperature is suppressed from changing) during continuous operation by suppressing the heat from being generated by the operation of the element. In order to control the device temperature during operation (to suppress device temperature from changing), it is necessary to decrease the induction loss (tan δ) of the piezoelectric material 1 and/or decrease device resistance.

Since thickness of the piezoelectric layer changes depending on the degree of polarization, it is necessary to decrease the induction loss (tan $\delta$) of the piezoelectric material so that the state of polarization after continuous operation remains the same as that before the continuous operation, in order to maintain the change in thickness of the piezoelectric layer constant after continuous operation. When temperature of the piezoelectric layer becomes higher than Curie point, the state of polarization during continuous operation becomes different from the state of polarization before continuous operation, thus making thickness and the amount of displacement of the piezoelectric layer more prone to change after continuous operation. Therefore, it is necessary to suppress the device temperature from rising. Thus it is required to decrease the specific resistance of the electrode material thereby to suppress the device temperature from rising during operation.

In case the piezoelectric layer 1 is formed by using perovskite type oxide consisting of $PbZrO_3$-$PbTiO_3$ as the main component, induction loss (tan $\delta$) may be decreased by firing the stack in oxygen-rich atmosphere, or by lowering the temperature more slowly from the highest firing temperature after firing the stack. Specifically, temperature lowering rate may be 600°C per hour or less, preferably 300°C per hour or less. Induction loss (tan $\delta$) may be below 1.5%, preferably 0.5% or lower.

Resistance of the device may be decreased by using a material of such a composition that has lower specific resistance to form the internal electrodes 2 and forming a dense structure that provides a sufficient path for current. Moreover, since the amount of displacement of the material that forms the piezoelectric layer 1 is desired to be independent of the operating temperature and remains constant, it is preferable to use a piezoelectric material that undergoes smaller displacement over the range of temperatures experienced by the element during continuous operation.

Furthermore, in order to remove the heat generated by the device efficiently to the outside, it is preferable to form the internal electrodes 2 that serve as the major path of heat transmission from a material that has high heat conductivity.

A method of manufacturing the multi-layer piezoelectric element of the first embodiment will now be described below.

First, a calcined powder of a piezoelectric ceramic material constituted from perovskite type oxide consisting of $PbZrO_3$-$PbTiO_3$ or the like, a binder made of an organic polymer such as acrylic resin or butyral resin and a plasticizer such as DOP (dioctyl phthalate) or DBP (dibutyl phthalate) are mixed to form a slurry. The slurry is formed into ceramic green sheets that would become the piezoelectric layers 1 by a known method such as doctor blade process or calender roll process or other tape molding method.

Then a metal powder such as silver-palladium that constitutes the internal electrode, a binder and a plasticizer are mixed to prepare an electrically conductive paste which is applied onto the top surface of the ceramic green sheet by screen printing method or the like to a thickness of 1 to 40 $\mu$m.

A plurality of the green sheets having the electrically conductive paste printed on the top surface thereof are stacked one on another, with the stack being heated at a predetermined temperature to remove the binder. The stack is then fired at a temperature in a range from 900 to 1200°C thereby to make the stack.

The method of making the stack is not limited to that described above, and any manufacturing method may be employed as long as the stack can be made in such a constitution as a plurality of the piezoelectric layers 1 and a plurality of the internal electrodes 2 are stacked alternately one on another.

The stack is made so that an end of the internal electrode is exposed on the side face of the stack in every other layer. A groove may be formed in the piezoelectric material located between the internal electrode 2 of which end is not exposed and the external electrode 4, with the groove filled with an insulating material such as resin or rubber that has Young's modulus lower than that of the piezoelectric material 1. The groove is formed on the side face of the stack by means of a dicing apparatus or the like.

Then an electrically conductive silver-glass paste is prepared by adding a binder to a glass powder, and the mixture is formed into a sheet that is dried to remove solvent while controlling the density of the green sheet in a range from 6 to 9 g/cm$^3$. The sheet is transferred onto the external electrode forming surface of the column-like stack, and is bonded by baking at a temperature that is higher than the softening point of the glass and is not higher than the melting point (965°C) of silver and is not higher than 4/5 of the firing temperature (°C). In this process, the binder contained in the sheet that is formed from the electrically conductive silver-glass paste is evaporated and removed, so that the external electrode 4 is formed from a porous electrical conductor having 3-dimensional mesh structure.

The electrically conductive material that constitutes the external electrode 4 is preferably silver that has a low value of Young's modulus or an alloy based on silver, in consideration of the capability to sufficiently absorb the stress generated by the expansion and contraction of the actuator.

The temperature at which the electrically conductive silver-glass paste is bonded by baking is preferably in a range from 550 to 700°C for the purpose of joining the silver content that is included in the electrically conductive silver-glass paste and the internal electrode 2 through diffusion bonding so as to form an effective neck, effectively causing the voids existing in the external electrode 4 to remain and partially joining the external electrode 4 and the side face of the column-like stack. Softening point of the glass component contained in the electrically conductive silver-glass paste is preferably in a range from 500 to 700°C.

When the baking temperature is higher than 700°C, sintering of the silver powder of the electrically conductive silver-glass paste would proceed excessively, such that the porous electrical conductor of 3-dimensional mesh structure cannot be effectively formed and the external electrodes 4 become too dense. As a result, the value of Young's modulus of the external electrode 4 becomes too high to effectively absorb the stress generated during operation, eventually leading to breakage of the external electrode 4. Baking is preferably carried out at a temperature that is not higher than 1.2 times the softening point of the glass.

When the baking temperature is lower than 550°C, on the other hand, the end of the internal electrode 2 and the external electrode 4 cannot be joined sufficiently through diffusion bonding, and therefore the neck cannot be formed thus giving rise to the possibility of spark occurring between the internal electrode 2 and the external electrode 4 during operation.

Thickness of the sheet formed from the electrically conductive silver-glass paste is preferably smaller than the thickness of the piezoelectric layer 1. More preferably, the thickness is 50 μm or less in order to accommodate the contraction and expansion of the actuator. By forming the external electrode 4 as described above, the multi-layer piezoelectric element of the first embodiment is completed.

Then the stack having the groove formed on the side face thereof to reach the inner electrode and the external electrodes 4 formed thereon is immersed in a silicone rubber solution while deaerating the silicone rubber solution by evacuation, so as to fill the groove of the stack with the silicone rubber. Then the stack is pulled out of the silicone rubber solution and is coated with the silicone rubber on the side faces thereof. Then the silicon rubber that fills the groove and covers the side faces of the column-like stack is cured, thereby to complete the multi-layer piezoelectric element of the present invention.

Then lead wires are connected to the external electrodes 4, and DC voltage of 0.1 to 3 kV/mm is applied between the pair of external electrodes 4 via the lead wires so as to apply polarization treatment to the stack, thereby to complete the multi-layer piezoelectric actuator that utilizes the multi-layer piezoelectric element of the present invention. When the lead wires are connected to an external voltage source and the voltage is supplied via the lead wires and the external electrodes 4 to the internal electrodes 2, the piezoelectric layers 1 undergo a significant amount of displacement by the reverse piezoelectric effect. The multi-layer piezoelectric actuator of the first embodiment constituted as described above can be used, for example, as an automobile fuel injection valve that supplies fuel to an engine.

Second Embodiment

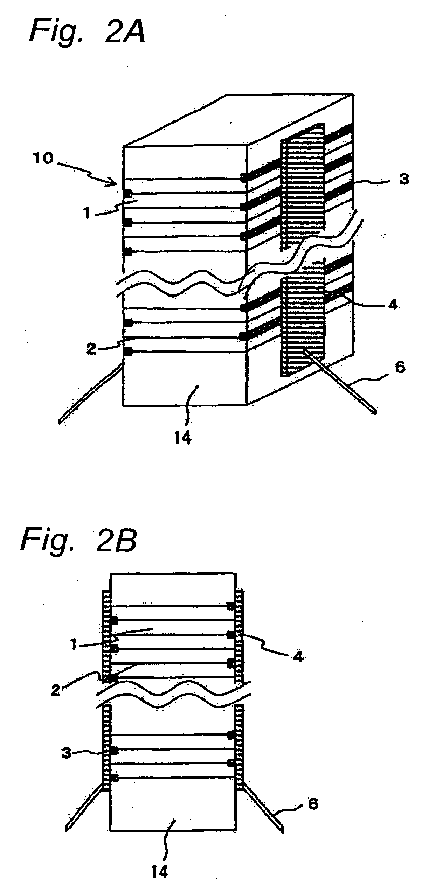

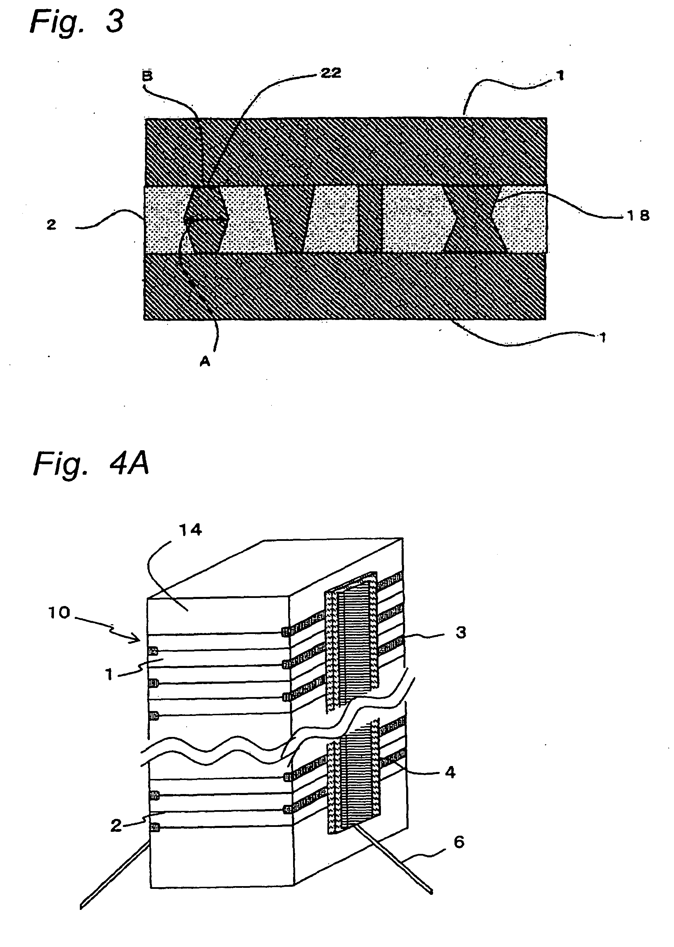

Fig. 2A is a perspective view showing the constitution of the multi-layer piezoelectric actuator according to the second embodiment of the present invention, and Fig. 2B is a side view thereof. Fig. 3 is a sectional view of a part of the internal electrode 2.

The multi-layer piezoelectric actuator according to the second embodiment has such a constitution as the external electrodes 4 are provided on the side faces of a stack 10 having rectangular prism shape formed by alternately stacking the piezoelectric layers 1 and the internal electrodes 2 as shown in Figs. 2A and 2B, so that one end of the internal electrode 2 is covered by an insulating material 3 in every other layer and the external electrode 4 is connected to the end of the internal electrode 2 that is not covered by the insulating material 3. The external electrode 4 is formed from a porous electrical conductor made of an electrically conductive material containing silver as the main material and glass, while lead wires 6 are connected to the external electrodes 4.

The multi-layer piezoelectric actuator according to the second embodiment is particularly **characterized in that** a plurality of pillars 18 are provided to penetrate the internal electrode 2 and connect two piezoelectric layers 1 that oppose each other as shown in Fig. 3. By forming the pillars 18 from a hard material such as ceramics disposed between the piezoelectric layers 1, it is made possible to increase the rigidity of the internal electrodes 2 and suppress the displacement of the internal electrodes 2 from being absorbed, thus achieving stable displacement. As a result, it is made possible to minimize the variation in the amount of displacement among products and improve the reliability. Variation in the amount of displacement after operation over a long period of time is also decreased, and reliability can be improved.

It is also preferable that not less than 30% of the pillars 18 have diameter B in the section 22 of the junction between the pillars 18 and the piezoelectric layer 1 not smaller than 50% of the maximum diameter A of the pillars 18 as shown in Fig. 3. This constitution enables it to achieve more stable displacement. Specifically, when 30% or more of the pillars 18 have diameter B in the section 22 of the junction between the pillars 18 and the piezoelectric layer 1 that is not smaller than 50% of the maximum diameter A of the pillars 18, strength of the pillars 18 and the piezoelectric layer 1 is increased and rigidity also becomes higher. This makes it possible to suppress the difference in the amount of displacement among the products, and improve the reliability. It is also made possible to decrease the change in the amount of displacement after a long period of operation and improve durability. For a similar reason, it is more preferable that not less than 50% of the pillars 18 have diameter B in the section 22 of the junction between the pillars 18 and the piezoelectric layer 1 not smaller than 50% of the maximum diameter A of the pillars 18.

Maximum diameter A and diameter B are measured as follows. First, maximum diameter A and diameter B in the section 22 of the junction between the pillars 18 and the piezoelectric layer 1 are measured for each pillar 18 in a photograph of a section of the multi-layer piezoelectric element on a region near the internal electrode 2. Value of $(B/A) \times 100$ is calculated from these measurements, so as to determine the ratio of diameter B in the section 22 of the junction between the pillars 18 and the piezoelectric layer 1 to the maximum diameter A for each pillar 18. Proportion of the pillars having this ratio not less than 50% to the number of pillars measured is calculated. This operation is carried out at ten points and the results are averaged.

According to the second embodiment, mean value of minimum diameters of the pillars 18 is 0.2 $\mu$m or larger, more preferably 0.3 $\mu$m or larger. This enables it to increase the strength of the pillars 18 which become less likely to break. As a result, variation in the amount of displacement is suppressed, making it possible to decrease the change in the amount of displacement after long period of operation and improve durability.

In the multi-layer piezoelectric element of the present invention, it is preferable that the number of pillars 18 per 1 mm in the section near the internal electrode 2 is from 5 to 150, more preferably from 10 to 100. This is because rigidity can be improved and the multi-layer piezoelectric element having high reliability with less variation in the amount of displacement can be made by providing such a number of pillars 18 as described above. The effect of providing the pillars is insufficient when the number of pillars 18 is less than 5. When the number of pillars 18 is more than 100, function of the internal electrodes 2 diminishes as resistance thereof increases such that heat is generated therefrom.

It is also preferable that the difference in thermal expansion coefficient between the pillar 18 and the piezoelectric layer 1 is $3 \times 10^{-5}$/°C or less, more preferably $2 \times 10^{-5}$/°C or less. This decreases the internal stress between the piezoelectric layer 1 and the pillar 18, increases the strength of adhesion in the interface and improves the durability. When PZT is used in the piezoelectric layers 1, PZT, $Al_2O_3$, $ZrO_2$, $TiO_2$, $SiO_2$ or the like may be used as the material to form the pillars 18 having difference in thermal expansion coefficient not larger than $3 \times 10^{-5}$/°C.

It is also preferable that the pillar 18 and the piezoelectric layer 1 are made of the same material. This decreases the internal stress between the piezoelectric layer 1 and the pillar 18 further, increases the strength of adhesion in the interface and improves the durability.

The pillars 18 can be formed by mixing a powder of material that makes the pillar 18 in the internal electrodes 2, and holding the temperature while raising the temperature in the firing process at least once at a temperature that is not lower than 80% of the maximum temperature of firing. That is, unlike the conventional firing process, a temperature that is not lower than 80% of the maximum temperature of firing is maintained for a while after degreasing, so that the powder of material that makes the pillar 18 mixed in the internal electrodes 2 is influenced by the surrounding metal composition and turns into such a state that makes it easier for grains to grow. Then as the material is fired at the maximum temperature, grains grow so as to link between the piezoelectric layers 1, so that pillars 18 are formed that penetrate the internal electrodes 2 and connect the piezoelectric layers 1 that oppose each other via the internal electrode 2. Proportion of the powder of material that makes the pillar 18 added to the internal electrodes 2 is from 5 to 40% by weight. When more than 40% by weight is added, resistance of the electrode may become too high thus resulting in heat generation. When less than 5% by weight is added, the pillars cannot be formed sufficiently, thus resulting in insufficient effect of improving the rigidity of the internal electrode and making it impossible to sufficiently improve the reliability and durability.

A method of manufacturing the multi-layer piezoelectric element of the second embodiment will now be described below.
First, ceramic green sheets that would become the piezoelectric layers 1 are made similarly to the first embodiment.
Then a metal powder such as silver-palladium that constitutes the internal electrode is mixed with at least one kind of ceramic powder such as PZT, $Al_2O_3$, $ZrO_2$, $TiO_2$, $SiO_2$ as the material to form the pillars 18, a binder and a plasticizer are mixed to prepare an electrically conductive paste. The electrically conductive paste is applied onto the top surface of the ceramic green sheet by screen printing method or the like to a thickness of 1 to 40 $\mu$m.

A plurality of the green sheets having the electrically conductive paste printed on the top surface thereof are stacked one on another, with the stack being heated at a predetermined temperature to remove the binder. After holding the stack a temperature that is not lower than 80% of the maximum temperature of firing for a while, the stack is fired at the maximum temperature in a range from 900 to 1200°C. The length of period during which the temperature not lower than 80% of the maximum temperature is maintained is preferably longer than 0.25 hours, and may consist of two or more steps. For example, the material may be heated in multiple steps in which the temperature is held at a level from 80% to 90% of the maximum temperature. It is necessary to hold a temperature that is not lower than 80% of the maximum temperature of firing for a while in order to cause the pillars to grow. This enables it to firmly connect the opposing piezoelectric layers. The maximum temperature is set in a range from 900 to 1200°C because dense piezoelectric layers cannot be formed at a temperature below 900°C, and stress generated by the difference in shrinkage between the electrodes and the piezoelectric layers becomes larger during firing and causes cracks during continuous operation when the maximum temperature is higher than 1200°C.

Then a groove is formed between the internal electrode 2 of which end is not exposed and the side face in such a configuration as the end of the internal electrode is exposed in every other layer on the side face of the multi-layer piezoelectric element, with the groove being filled with an insulating material such as resin or rubber that has Young's modulus lower than that of the piezoelectric layer 1. The groove 3 may be formed by means of a dicing apparatus or the like.

Then the external electrodes 4 are formed similarly to the first embodiment.
Then the stack 10 having the external electrodes 4 formed thereon is immersed in a silicone rubber solution while deaerating the silicone rubber solution by evacuation, so as to fill the groove of the stack 10 with the silicone rubber. Then the stack 10 is pulled out of the silicone rubber solution and is coated with the silicone rubber on the side faces thereof. Then the silicon rubber that fills the groove and covers the side faces of the stack 10 is cured.
When lead sires are connected to the external electrodes 4, the multi-layer piezoelectric element of the present invention is completed.

Then DC voltage of 0.1 to 3 kV/mm is applied between the pair of external electrodes 4 via the lead wires so as to apply polarization treatment to the stack 10, thereby to complete the multi-layer piezoelectric actuator as a product. When the lead wires are connected to an external voltage source and the voltage is supplied via the lead wires and the external electrodes 4 to the internal electrodes 2, the piezoelectric layers 1 undergo a significant amount of displacement by the reverse piezoelectric effect, thus functioning as an automobile fuel injection valve that supplies fuel to an engine.

In the multi-layer piezoelectric element constituted as described above, the internal electrodes 2 have high rigidity and improved bonding strength, thus enabling it to decrease the amount of displacement absorbed by the internal electrodes. Also because delamination does not occur when subjected to continuous operation, change in the amount of displacement can be made smaller. As a result, a piezoelectric actuator that has high reliability and is free from malfunction can be provided.
The multi-layer piezoelectric element of the second embodiment is not limited to the examples described above, and various modifications may be made within the scope of the present invention.

Third Embodiment

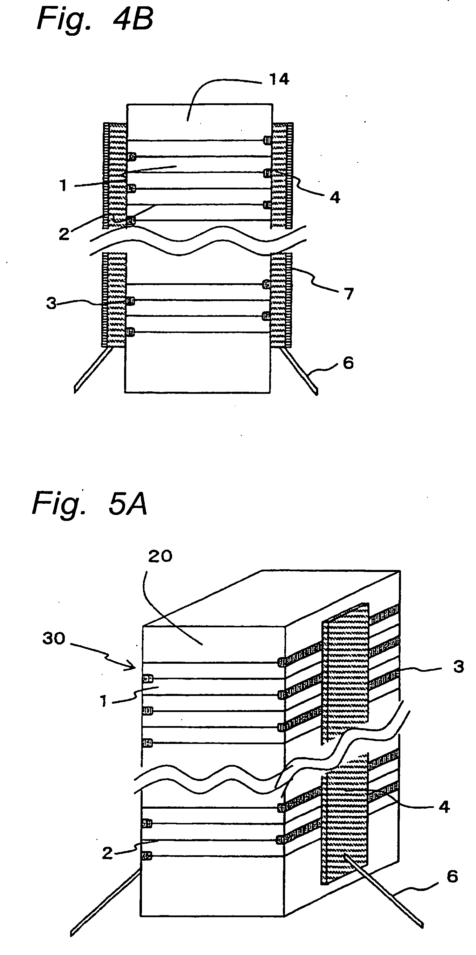

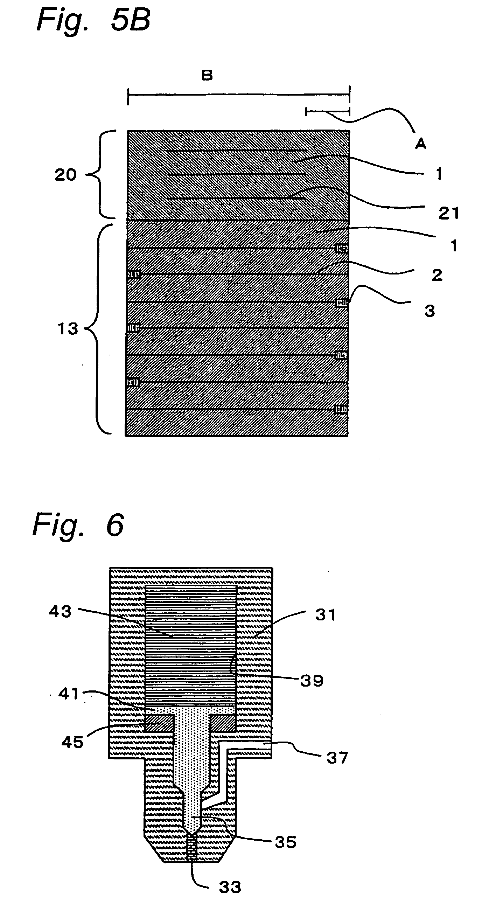

Figs. 5A and 5B show multi-layer piezoelectric element according to the third embodiment of the present invention. Fig. 5A is a perspective view and Fig. 5B is a sectional view showing the state of the piezoelectric layers, the internal electrode layers, the protective sections and the dummy layers being stacked one on another.

The multi-layer piezoelectric element according to the third embodiment has the external electrodes 4 formed on a pair of opposing side faces of a stack 30 formed by stacking the piezoelectric layers 1 and the internal electrodes 2 alternately, where the internal electrodes 2 are provided so as to electrically connect to the external electrode 4 in every other layer. In the multi-layer piezoelectric element according to the third embodiment, the stack 30 has such a constitution as inactive protective sections 20 are formed by alternately stacking the piezoelectric layers 1 and the dummy layers 21 on the top and bottom of a stacked drive section 13.

The multi-layer piezoelectric element of the third embodiment is, in particular, constituted such that the ratio of minimum distance A between the periphery of the dummy layer 21 and the side face of the stack to the width B of the inactive protective layer 20, A/B, is in a range from 0.01 to 0.08 in a cross section perpendicular to the direction of stacking of the stack 30. The invention related to the third embodiment has been completed based on finding that, by setting the minimum distance A and the width B of the inactive protective section 20 in the range described above, it is made possible to make a multi-layer piezoelectric element of high reliability that does not undergo change in the characteristics after long period of operation.

When the ratio A/B is less than 0.01, the region of junction between the piezoelectric layers becomes too small, and the stress generated in the dummy layer 21 by deformation during operation over a long period of time exceeds the force of connecting the piezoelectric layers, thus increasing the possibility of delamination to occur.

When the ratio A/B is larger than 0.08, difference in the magnitude and profile of shrinkage between the inactive protective section 20 and the stacked drive section 13 during firing causes a significant strain between these members larger than the bonding strength between the piezoelectric layers. This results, in a worst case, in delamination after firing or delamination caused by operation over a long period of time.

According to the present invention, the ratio A/B is preferably in a range from 0.02 to 0.07, more preferably from 0.03 to 0.06. This makes delamination of the inactive protective section 20 less likely to occur, thus improving durability.
The dummy layer 21 preferably contains metal. This mitigates the stress generated between the piezoelectric layers 1 and enables it to operate over a long period of time with improved durability. The metal may be a metallic element such as Ag, Cu, Ni, Pd or the like, and an alloy formed from one or more thereof. The dummy layer may also contain glass.

It is preferable that the dummy layer 21 is formed from the same material as that of the internal electrode 2. This causes the inactive protective section 20 and the stacked drive section 13 to behave substantially the same way during firing, so that stress is suppressed from being generated between these members, possibility of delamination is decreased and a piezoelectric element having improved durability is obtained.

Thickness of the piezoelectric layer 1 is preferably not less than 50 $\mu$m. The piezoelectric layer 1, when formed with such a thickness, can endure the stress generated therein so as to prevent breaking.

It is also preferable that the dummy layer 21 contains an inorganic composition, that is at least one of metal oxide, nitride and carbide. Including the inorganic composition in the dummy layer 21 generates crosslinking of the inorganic composition between the piezoelectric layers 1, making it stronger against stress generated during firing or during use, so that delamination is less likely to occur and therefore durability is improved. For the inorganic composition, PZT, $Al_2O_3$, $ZrO_2$, $TiO_2$, $SiO_2$, TiN, $Si_3N_4$, AlN, SiC, TiC or the like may be used.

It is preferable that the dummy layer 21 contains 2% by weight or more inorganic composition. This makes the crosslinking between the piezoelectric layers 1 sufficient, resulting in increased strength of joining the piezoelectric layers 1, decreased possibility of delamination and improved durability.

A method of manufacturing the multi-layer piezoelectric element of the third embodiment will now be described below. According to this method, first, ceramic green sheet that would become the piezoelectric layers 1 is formed similarly to the first embodiment.

The green sheet is cut into an appropriate size and secured on a frame for controlling the ratio A/B.

Then a metal powder such as silver-palladium that constitutes the internal electrode 2, a binder and a plasticizer are mixed to prepare an electrically conductive paste which is applied onto the top surface of the ceramic green sheet by screen printing method or the like to a thickness of 1 to 40 $\mu$m, thereby preparing the green sheet to form the stacked drive section 13.

Similarly, the dummy layer that contains silver-palladium or the like is formed on the top surface of the green sheet by screen printing method or the like to a thickness of 1 to 40 $\mu$m, thereby preparing the green sheet to form the inactive protective section 20. The printing operation is carried out while controlling the ratio A/B to a predetermined value taking into consideration the shrinkage caused by firing.

In order to control the ratio A/B, a plurality of the inactive protective sections 20 are stacked on top and bottom of the green sheet to form the stacked drive section 13 with the electrically conductive paste being printed on the top surface thereof and the green sheet to form the inactive protective section 20, which are bonded together by applying a pressure. The minimum distance A between the periphery of the dummy layer 21 and the side face of the inactive protective 20 can be controlled by securing the green sheet onto the frame and bonding the inactive protective section 20 and the stacked drive section 13 together.

Then the green sheet is cut into an appropriate size and is heated at a predetermined temperature to remove the binder, before being fired at a temperature in a range from 900 to 1200°C thereby to make the multi-layer piezoelectric element.

The method of making the multi-layer piezoelectric element is not limited to that described above, and any manufacturing method may be employed as long as the minimum distance A between the periphery of the dummy layer 21 and the side face of the inactive protective 20 can be controlled.

The internal electrode 2 of which end is exposed on the side face of the multi-layer piezoelectric element and the internal electrode 2 of which end is not exposed are stacked alternately, while a groove 3 is formed in the piezoelectric layer 1 located between the internal electrode 2 of which end is not exposed and the external electrode 4, with the groove 3 being filled with an insulating material such as resin or rubber having Young's modulus lower than that of the piezoelectric material 1. The electrically conductive material that constitutes the external electrode 4 on the side faces of the stacked drive section 13 is preferably silver that has a low value of Young's modulus or an alloy based on silver, in consideration of the capability to sufficiently absorb the stress generated by the expansion and contraction of the actuator.

Then the external electrodes 4 are formed similarly to the first embodiment.

Then the stacked drive section 13 having the external electrodes 4 formed thereon is immersed in a silicone rubber solution while deaerating the silicone rubber solution by evacuation, so as to fill the groove 3 of the stacked drive section 13 with the silicone rubber. Then the stacked drive section 13 is pulled out of the silicone rubber solution and is coated with the silicone rubber on the side faces of the stacked drive section 13. Then the silicon rubber that fills the groove 3 and covers the side faces of the column-like stack 13 is cured, thereby to complete the multi-layer piezoelectric element of the present invention.

Then lead wires 6 are connected to the external electrodes 4, and DC voltage of 0.1 to 3 kV/mm is applied between the pair of external electrodes 4 via the lead wires 6 so as to apply polarization treatment to the stacked drive section 13, thereby to complete the multi-layer piezoelectric actuator that utilizes the multi-layer piezoelectric element of the present invention. When the lead wires 6 are connected to an external voltage source and the voltage is supplied via the lead wires and the external electrodes 4 to the internal electrodes 2, the piezoelectric layers 1 undergo a significant amount of displacement by the reverse piezoelectric effect so as to function, for example, as an automobile fuel injection valve that supplies fuel to an engine.

Preferred embodiment of the constitution including the internal electrodes, external electrodes and other components of the multi-layer piezoelectric element according to the first through third embodiments will now be described.

<Internal electrode>

According to the present invention, it is preferable that the metal composition in the internal electrode 2 contains group VIII metal and/or group Ib metal as the main components. Since these metal compositions have high heat resistance and therefore allows the piezoelectric layers 1 that have a higher firing temperature and the internal electrodes 2 to be fired at the same time.

It is preferable that such a metal composition is contained in the internal electrode 2 as the main component that proportion M1 (% by weight) of the group VIII metal and proportion M2 (% by weight) of the group Ib metal in the metal composition of the internal electrode 2 satisfy the relations $0 < M1 \leq 15$, $85 \leq M2 < 100$ and $M1 + M2 = 100$. This is because proportion of the group VIII metal higher than 15% by weight results in high specific resistance of the internal electrode 2 which causes the internal electrodes 2 to generate heat when the multi-layer piezoelectric element is operated continuously over a long period of time. In order to suppress the group Ib metal contained in the internal electrode 2 from migrating into the piezoelectric layers 1, it is preferable to control the proportion of the group VIII metal in a range from 0.001 to 15% by weight. For the purpose of improving the durability of the multi-layer piezoelectric element, proportion of the group VIII metal is preferably in a range from 0.1 to 10% by weight. In case excellent heat conductivity and higher durability are required, proportion of the group VIII metal is preferably in a range from 0.5 to 9.5% by weight. In order to improve the durability further, proportion of the group VIII metal is preferably in a range from 2 to 8% by weight.

Proportion of the group Ib metal is preferably 85% by weight or more because proportion of the group Ib metal lower than 85% by weight results in high specific resistance of the internal electrode 2 which causes the internal electrodes 2 to generate heat when the multi-layer piezoelectric element is operated continuously over a long period of time. In order to suppress the group Ib metal contained in the internal electrode 2 from migrating into the piezoelectric layers 1, it is preferable to control the proportion of the group Ib metal in a range from 85 to 99.999% by weight. For the purpose of improving the durability of the multi-layer piezoelectric element, proportion of the group Ib metal is preferably in a range from 90 to 99.9% by weight. In case higher durability is required, proportion of the group Ib metal is preferably in a range from 90.5 to 99.5% by weight. In order to improve the durability further, proportion of the group Ib metal is preferably in a range from 92 to 98% by weight.

The group VIII metal and the group Ib metal in the internal electrode 2 can be identified by analytical method such as EPMA (Electron Probe Micro Analysis).

Metal elements contained in the internal electrode 2 of the present invention are preferably the group VIII metal that is at least one kind selected from among Ni, Pt, Pd, Rh, Ir, Ru and Os, and the group Ib metal that is at least one kind selected from among Cu, Ag and Au, since such a metal composition is advantageous in volume production when the alloy powder synthesizing technology available today is employed.

Further, it is preferable that the group VIII metal contained in the internal electrode 2 is at least one kind selected from among Pt and Pd, and the group Ib metal is at least one kind selected from among Ag and Au. This composition makes it possible to form the internal electrode 2 having high heat resistance and low specific resistance.

Further, it is preferable that the group VIII metal contained in the internal electrode 2 is Ni and the group Ib metal is Cu. This composition makes it possible to form the internal electrode 2 having higher heat resistance and high heat conductivity.

Further it is preferable to add oxide, nitride or carbide along with the metallic component in the internal electrode 2. This increases the bonding strength between the internal electrode 2 and the piezoelectric material 1, thereby improving the durability of the multi-layer piezoelectric element.

It is preferable that the oxide described above includes perovskite type oxide consisting of $PbZrO_3$-$PbTiO_3$ as the main component. Contents of oxide can be determined from the composition of the area ratio of the corresponding grains in the internal electrode measured on an SEM photograph of a section of the multi-layer piezoelectric element.

The deviation in the composition of the internal electrode 2 that is caused by the firing operation is preferably not larger than 5%. This is because a deviation larger than 5% in the composition of the internal electrode 2 caused by the firing operation causes a greater amount of the metallic component contained in the internal electrode 2 to migrate into the piezoelectric layer 1, thus making it impossible for the internal electrode 2 to deform in conformity with the expansion and contraction of the multi-layer piezoelectric element during operation. The electrodes can be restricted from becoming too hard by controlling the deviation in the composition of the electrode after the firing within 5%.

The deviation in the composition of the internal electrode 2 refers to the variation in the composition of the internal electrode 2 caused by evaporation of the elements that constitute the internal electrode 2 due to firing or diffusion thereof into the piezoelectric material 1.

In the multi-layer piezoelectric element of the present invention, it is also preferable that the internal electrodes include voids and the voids occupy 5 to 70% of cross sectional area of the internal electrodes. This decreases the restrictive force exerted by the internal electrode on the deformation of the piezoelectric material under the effect of electric field, thereby increasing the amount of displacement of the piezoelectric material. It also provides such an advantage that stress generated in the internal electrode is mitigated by the voids, thereby improving the durability of the device. In addition, while heat transfer within the device is predominantly carried by the internal electrodes, existence of the voids in the internal electrode mitigates the change in temperature within the device caused by rapid changes in the temperature outside of the device, thus making the device more resistant to thermal shock.

In the first through third embodiments, it is preferable that the internal electrodes 2 include voids and the ratio of area occupied by the voids to the entire sectional area (hereinafter referred to as the void ratio) is from 5 to 70% in the section of the internal electrodes 2.

When the multi-layer piezoelectric element is constituted by using the internal electrodes 2 that include the voids as described above, the multi-layer piezoelectric element of high durability is obtained. When the void ratio in the internal electrodes 2 is less than 5%, the restrictive force exerted on the deformation of the piezoelectric material increases, resulting in insufficient effect of the voids. Void ratio in the internal electrodes 2 more than 70% is not desirable since it results in the internal electrodes 2 having electrical conductivity that is too low and strength that is too weak. In order to improve durability of the device, void ratio in the internal electrodes 2 is preferably in a range from 7 to 70%. Greater amount of displacement and high durability can be achieved by controlling the void ratio in the internal electrodes 2 in a range from 10 to 60%.

The void ratio in the section of the internal electrodes 2, which is the ratio of area occupied by the voids to the entire sectional area of the internal electrodes 2 as described above, can be determined as follows.

The multi-layer piezoelectric element is cut along a plane parallel to the direction of stacking. Total area of one of the internal electrodes 2 exposed in the section and the area occupied by the voids are measured while observing, for example, under a microscope. Void ratio in the section of the internal electrodes 2 ((Area occupied by the voids)/ Total area) $\times$ 100) is calculated from the ratio of areas.

The internal electrodes 2 that include the voids can be made as follows.

First, two or more kinds of materials having different melting points are prepared for the metal powders used to make the internal electrodes 2, so that voids are formed in the internal electrodes 2 after firing. Alloy may also be used as the metallic material depending on the application.

The material is calcined at a temperature not lower than the melting point of the metal that has the lowest melting point among the metal powders used to make the internal electrodes 2 and not higher than the melting point of the metal that has the highest melting point. When the material is calcined at such a temperature, the metal or alloy that has the melting point lower than the firing temperature among the metal powders that constitute the internal electrodes 2 melts and flows due to the capillary effect through the space between the metal powders that have not melted, so as to leave voids where it originally existed. With this method, the void ratio in the internal electrodes 2 can be controlled to a desired value by adjusting the proportions of mixing the two or more kinds of metal powders used to make the internal electrodes 2 and controlling the temperature.

Voids in the internal electrodes 2 may also be formed by making use of minute spaces created between the particles of the metal powder when preparing the electrically conductive paste used to form the internal electrodes 2, or the spaces left by burning out of the binder contained in the electrically conductive paste.

Alternatively, the voids in the internal electrode 2 may also be formed by adding a material, that has low wettability with regards to the materials that constitute the internal electrode 2, to the electrically conductive paste used in forming the internal electrode 2, or by coating the green sheet of the piezoelectric material, whereon the electrically conductive paste of the internal electrode 2 is to be printed, with a material that has low wettability with regards to the materials that constitute the internal electrode 2. For the material that has low wettability with regards to the materials that constitute the internal electrode 2, for example, BN can be used.

<Piezoelectric layer 1>

It is further preferable that the piezoelectric material 1 includes perovskite type oxide as the main component. This is because the piezoelectric material 1 formed from perovskite type oxide such as barium titanate ($BaTiO_3$) has high piezoelectric strain constant $d_{33}$ which enables it to increase the amount of displacement. This constitution also enables the piezoelectric material 1 and the internal electrode 2 to be fired at the same time. It is also preferable that the piezoelectric material 1 contains perovskite type oxide consisting of $PbZrO_3$-$PbTiO_3$ that has a relatively high value of piezoelectric strain constant $d_{33}$ as the main component.

The firing temperature is preferably in a range from 900 to 1000°C. When the firing temperature is lower than 900°C, the firing process does not fully proceed, and it becomes difficult to make dense piezoelectric material 1. When the firing temperature is higher than 1000°C, larger stress is generated due to the difference in contraction between the internal electrode 2 and the piezoelectric material 1 when fired, thus resulting in cracks occurring during continuous operation of the multi-layer piezoelectric element.

<Connection and insulation between internal electrode and external electrode>

It is preferable that the internal electrode 2 of which end is exposed on the side face of the multi-layer piezoelectric element of the present invention and the internal electrode 2 of which end is not exposed are stacked alternately, while the groove is formed in the piezoelectric layer located between the internal electrode 2 of which end is not exposed and the external electrode 4, with the groove being filled with an insulating material having Young's modulus lower than that of the piezoelectric material 1. In the multi-layer piezoelectric element having such a constitution, stress generated by the displacement during operation can be mitigated and therefore heat generation from the internal electrodes 2 can be suppressed even during continuous operation.

<External electrode 4>

According to the present invention, the external electrodes 4 are formed from a porous electrical conductor having 3-dimensional mesh structure, as shown in Figs. 4A and 4B. Unless the external electrodes 4 are formed from a porous electrical conductor having 3-dimensional mesh structure, the external electrodes do not have flexibility and cannot follow the expansion and contraction of the multi-layer piezoelectric actuator, eventually causing breakage of the external electrodes 4 and/or contact failure between the external electrode 4 and the internal electrode 2. The 3-dimensional mesh structure means, rather than such a state as spherical voids are contained in the external electrodes 4, that the powders of electrically conductive material and glass that constitute the external electrodes 4 are baked at a relatively low temperature and therefore sintering reaction does not fully proceed so that the voids are connected to each other to a certain extent, thereby forming 3-dimensional configuration of the powders of electrically conductive material and glass that constitute the external electrodes 4 being bonded with each other.

Void ratio in the external electrode 4 is preferably in a range from 30 to 70% by volume. The void ratio means the proportion of the volume occupied by the voids 4a in the external electrodes 4. When the void ratio in the external electrode 4 is less than 30%, the external electrodes 4 may not be capable of enduring the stress generated by the expansion and contraction of the multi-layer piezoelectric actuator, eventually leading to breakage of the external electrode 4. When the void ratio in the external electrode 4 is higher than 70%, resistance of the external electrode 4 becomes higher and the external electrode 4 may be broken due to localized heating when a large current flows.

It is also preferable that a glass-rich layer is formed on the surface of the external electrode 4 on the side of the surface of the piezoelectric layer 1. This is because, without the glass-rich layer, it is difficult to bond the glass component in the external electrodes 4, and firm bonding between the external electrode 4 and the piezoelectric layer 1 cannot be easily achieved.

It is also preferable that softening point (°C) of the glass that constitutes the external electrode 4 is not higher than 4/5 times the melting point (°C) of the electrically conductive material that constitutes the internal electrode 2. This is because, when the softening point of the glass that constitutes the external electrode 4 is higher than 4/5 times the melting point of the electrically conductive material that constitutes the internal electrode 2, the softening point of the glass that constitutes the external electrode 4 and the melting point of the electrically conductive material that constitutes the internal electrode 2 become approximate to each other. Such a condition results in coagulation of the electrically conductive material of the internal electrodes 2 and the external electrodes 4 that impedes the joining through diffusion from taking place. Also it makes it impossible to set the baking temperature at a proper temperature for the glass component of the external electrode 4 to soften, resulting in failure to achieve sufficient strength of bonding by the softened glass. It is also preferable that a glass-rich layer is formed on the surface of the external electrode 4 on the side of the surface of the piezoelectric layer 1. This is because, without the glass-rich layer, it is difficult to bond the glass component in the external electrodes 4, and firm bonding between the external electrode 4 and the piezoelectric layer 1 cannot be easily achieved.

The glass that constitutes the external electrodes 4 is preferably amorphous. This is because the external electrodes 4 constituted from crystalline glass is not capable of absorbing the stress generated by the expansion and contraction of the actuator, and may be cracked.

It is also preferable that thickness of the external electrodes 4 is greater than thickness of the piezoelectric layer 1. This is because the external electrodes 4 thicker than the piezoelectric layer 1 has higher strength, resulting in increasing load on the junction between the external electrodes 4 and the piezoelectric layer 1, eventually causing contact failure.

An electrical conductivity assisting member formed from an electrically conductive adhesive, including a metal mesh or a mesh-like metal sheet embedded therein, may be provided on the external surface of the external electrode 4. By providing the electrical conductivity assisting member on the external surface of the external electrode 4, it is made possible to cause a large current to flow in the electrical conductivity assisting member even when the device is operated at a high speed by supplying a large current to the actuator so as to decrease the current flowing in the external electrodes 4, thereby preventing the external electrodes 4 from breaking due to localized heat generation and greatly improving durability. Moreover, by embedding the metal mesh or a mesh-like metal sheet in the electrically conductive adhesive, it is made possible to prevent the electrically conductive adhesive from cracking.

The metal mesh refers to a structure of entwined metal wires, and the mesh-like metal sheet refers to a metal sheet with a number of holes punched therethrough.

It is further preferable that the electrically conductive adhesive that constitutes the electrical conductivity assisting member is polyimide resin containing electrically conductive particles dispersed therein.

The electrically conductive particles are preferably silver powder. This is because the use of silver powder that has relatively low specific resistance as the electrically conductive particles makes it easier to suppress localized heat generation by the electrically conductive adhesive.

When silver powder that has relatively low specific resistance is dispersed in polyimide resin that has high heat resistance, the electrical conductivity assisting member can maintain low resistivity and high bonding strength even when used at high temperatures. More preferably, the electrically conductive particles are non-spherical particles having such shapes as flakes or acicular particles. When the electrically conductive particles are non-spherical particles such as flakes or acicular particles, the electrically conductive particles can be firmly entwined with each other, thereby increasing the shear strength of the electrically conductive adhesive.

It is preferable that the multi-layer piezoelectric element of the present invention comprises a single plate or a stack of one or more layers. This constitution enables it to either transform a pressure applied to the device into a voltage or cause the device to displace by applying a voltage to the device. As a result, even when unexpected stress is generated during operation, stress can be mitigated by distributing the stress and converting it into voltage, thus making it possible to provide a piezoelectric actuator having excellent durability and high reliability.

The multi-layer piezoelectric element of the present invention is not limited to those described above, and various modifications may be made within the scope of the present invention.

While an example where the external electrodes 4 are formed on the opposing side faces of the stack has been described above, a pair of external electrodes may be formed, for example, on adjacent side faces according to the present invention.

Also according to the present invention, the stack is not necessarily required to have a shape of rectangular prism, but may have various shapes such as cylinder, polygonal prism or the like.

Fourth Embodiment

Fig. 6 shows the injection apparatus of the present invention, wherein the container 31 has the injection hole 33 formed at one end thereof, and the needle valve 35 that can open and close the injection hole 33 is housed in the container 31.

The injection hole 33 is provided with a fuel passage 37 in communication therewith. The fuel passage 37 is connected to a fuel source that is provided outside of the apparatus, so as to receive supply of the fuel at a high pressure that remains always constant. When the needle valve 35 opens the injection hole 33, the fuel that fills the fuel passage 37 is injected at a predetermined level of high pressure into a fuel chamber of an internal combustion engine that is not shown in the drawings.

The needle valve 35 has an enlarged top portion of a larger diameter so as to serve as a piston 41 that makes sliding motion in a cylinder 39 that is formed in the container 31. The piezoelectric actuator 43 is housed in the container 31.

With the injection apparatus as described above, when the piezoelectric actuator 43 is caused to expand by a voltage applied thereto, the piston 41 is pressed so that the needle valve 35 plugs the injection hole 33 and shuts off the fuel supply. When the voltage is removed, the piezoelectric actuator 43 contracts and a Belleville spring 45 presses back the piston 41 so that the injection hole 33 communicates with the fuel passage 37 thereby allowing the fuel to be injected.

The present invention relates to the multi-layer piezoelectric element and the injection apparatus, but is not limited to the embodiments described above. For example, the present invention can be applied to a fuel injection apparatus of automobile engine, a liquid ejecting apparatus of an ink jet printer or the like or a drive unit used in precision positioning device or vibration preventing device for an optical apparatus, or to sensor devices such as a sensor element mounted in combustion pressure sensor, knocking sensor, acceleration sensor, load sensor, ultrasound sensor, pressure sensor, yaw rate sensor or the like, or used as a circuit component mounted in piezoelectric gyro, piezoelectric switch, piezoelectric transducer, piezoelectric breaker or the like, and is also applicable to other purposes, as long as the piezoelectric characteristic is utilized.

EXAMPLES

Examples 1 through 3

The multi-layer piezoelectric actuator of the present invention was fabricated as described below in Examples 1 through 3.

First, a calcined powder of a piezoelectric ceramic material constituted from lead titanate zirconate ($PbZrO_3$-$PbTiO_3$) as the main component, a binder and a plasticizer were mixed to form a slurry which was formed into ceramic green sheets that would become the piezoelectric layer 1 having thickness of 150 $\mu$m by the doctor blade process.

An electrically conductive paste, prepared by adding a binder to the silver-palladium alloy made with an arbitrary composition, was applied to one side of the ceramic green sheet by screen printing method to a thickness of 3 $\mu$m. Then 300 pieces of the ceramic green sheets were stacked and fired at a temperature of 1000°C.

Then a groove measuring 50 $\mu$m in depth and 50 $\mu$m in width was formed at the end of the internal electrode located on the side face of the stack in every other layer, by means of a dicing apparatus.

Then 90% by volume of silver powder of flake-like particles having mean particle size of 2 $\mu$m and 10% by volume of amorphous glass powder having softening point of 640°C containing silicon as the main component having mean particle size of 2 $\mu$m were mixed, and 8 weight parts of a binder was added to 100 weight parts in total of the silver powder and the glass powder, so as to prepare the electrically conductive silver-glass paste by fully mixing the powders. The electrically conductive silver-glass paste thus prepared was screen printed onto a release film. After drying, the paste film was peeled off the release film to obtain a sheet of electrically conductive silver-glass paste. Density of the green sheet as measured by Archimedes method was 6.5 g/cm$^3$.

The sheet of the silver-glass paste was transferred onto the external electrode 4 surface of the stack and was baked at 650°C for 30 minutes, thereby forming the external electrode 4 from the porous electrically conductive material having 3-dimensional mesh structure. Measurement of void ratio of the external electrode 4 by means of image analysis apparatus on a photograph of a cut surface of the external electrode 4 showed a void ratio of 40%.

Then lead wires were connected to the external electrodes 4, and DC electric field of 3 kV/mm was applied between the positive and negative external electrodes 4 via the lead wires so as to apply polarization treatment for 15 minutes, thereby to complete the multi-layer piezoelectric actuator using the multi-layer piezoelectric element as shown in Fig. 1.

Example 1

With the multi-layer piezoelectric actuator of the present invention made by controlling resistance of the device and the induction loss (tan $\delta$) of the piezoelectric material 1 to a low level, rate of change in the amount of displacement of the device, rate of change in thickness of the piezoelectric layer, rate of change in resistance of the device and rate of change in device temperature after continuous operation of the multi-layer piezoelectric actuator were measured. These measurements were examined against the degree of deterioration of the multi-layer piezoelectric actuator caused by long period of operation.

The degree of deterioration is determined as follows. The amount of displacement of the device after operating the multi-layer piezoelectric actuator for an arbitrary number of cycles (the amount of displacement after continuous operation) is counted. Then the amount of displacement of the device after operating the multi-layer piezoelectric actuator for a predetermined number of cycles (the amount of displacement after a long period of operation) is counted. The degree of deterioration is defined as the ratio of the change in the amount of displacement after a long period of operation to the amount of displacement after continuous operation. This value enables it to examine the progress of deterioration, by operating the multi-layer piezoelectric actuator, that has been operated an arbitrary number of times, further for a predetermined number of cycles.

As Comparative Example, sample was made of which rate of change in displacement of the element or rate of change in resistance of the element before and after continuous operation of the multi-layer piezoelectric actuator exceeded 5%.

When a DC voltage of 170 V was applied to the multi-layer piezoelectric actuators made as described above, all the multi-layer piezoelectric actuators underwent displacement of 45 $\mu$m in the direction of stacking. Operation test was conducted on the multi-layer piezoelectric actuators by applying an AC voltage varying between 0 V and +170 V at frequency of 150 Hz at room temperature to carry out continuous operation of $1 \times 10^9$ cycles. Long-term operation test of $1 \times 10^{10}$ cycles was also conducted. The results are shown in Table 1. The ratio of change in thickness of the piezoelectric layer was determined by observing the side face of the multi-layer piezoelectric element under an SEM before operation to measure the thickness of the piezoelectric layer at 10 points and average the measurements, while measuring the thickness of the piezoelectric layer after the operation at the same points and averaging the measurements.

## EP 1 686 633 B1

Table 1-1

| No. | Resistance of internal electrode normalized resistance of 100% silver | Induction loss tan δ (%) of the piezoelectric material | Amount of displacement (μm) in initial state = A | Change (%) in device temperature after continuous operation (1 × 10$^9$ cycles) |
|---|---|---|---|---|
| 1 | 2 | 0.5 | 45.0 | 0.0 |
| 2 | 3 | 0.5 | 45.0 | 0.2 |
| 3 | 3.5 | 0.5 | 45.0 | 0.4 |
| 4 | 4 | 0.5 | 45.0 | 0.6 |
| 5 | 5 | 0.5 | 45.0 | 0.8 |
| 6 | 8 | 0.5 | 45.0 | 1.2 |
| 7 | 10 | 0.5 | 45.0 | 2.6 |
| 8 | 5 | 1.0 | 45.0 | 4.5 |
| *9 | 5 | 1.5 | 45.0 | 6.2 |

Table 1-2

| No. | Change (%) in thickness of piezoelectric layer after continuous operation (1 × 10$^9$ cycles) | Change (%) in resistance of element after continuous operation (1 × 109 cycles) | Maximum displacement (μm) after continuous operation (1 × 10$^9$ cycles) = B |
|---|---|---|---|
| 1 | 0.0 | 0.0 | 45.0 |
| 2 | 0.2 | 0.2 | 44.9 |
| 3 | 0.4 | 0.4 | 44.8 |
| 4 | 0.6 | 0.7 | 44.7 |
| 5 | 0.8 | 0.9 | 44.6 |
| 6 | 1.2 | 1.3 | 44.4 |
| 7 | 2.6 | 2.9 | 43.7 |
| 8 | 5.0 | 5.0 | 42.8 |
| *9 | 6.4 | 6.9 | 41.9 |

Table 1-3

| No. | Ratio of change (%) in displacement after continuous operation to initial displacement = \| (A-B)/A × 100 \| | Displacement after long-term operation (1 × 10$^{10}$ cycles) (μm) = C | Degree of deterioration (%) = \| (B - C ) /B × 100 \| |
|---|---|---|---|
| 1 | 0.0 | 45.0 | 0.00 |
| 2 | 0.2 | 44.9 | 0.00 |
| 3 | 0.4 | 44.7 | 0.22 |
| 4 | 0.7 | 44.6 | 0.22 |
| 5 | 0.9 | 44.4 | 0.45 |
| 6 | 1.3 | 44.1 | 0.68 |

19

(continued)

| No. | Ratio of change (%) in displacement after continuous operation to initial displacement = \| (A-B)/A $\times$ 100 \| | Displacement after long-term operation ($1 \times 10^{10}$ cycles) ($\mu$m) = C | Degree of deterioration (%) = \| (B - C ) /B $\times$ 100 \| |
|---|---|---|---|
| 7 | 2.9 | 43.2 | 1.14 |
| 8 | 5.0 | 41.9 | 2.10 |
| *9 | 6.9 | 38.5 | 8.11 |
| In the tables described above, sample marked with * is comparative example. | | | |

Table 1 shows that sample No. 9 that is a comparative example showed a change in displacement more than 5% after continuous operation. As a result, displacement of the multi-layer piezoelectric actuator measured after long-term operation of $1 \times 10^{10}$ cycles following continuous operation of $1 \times 10^9$ cycles showed significant decrease in the displacement after long-term operation of $1 \times 10^{10}$ cycles over the displacement after continuous operation of $1 \times 10^9$ cycles, indicating an increasing degree of deterioration and difficulty in continuously operating the multi-layer piezoelectric actuator.

With the change in resistance of the device more than 5% after continuous operation, displacement of the multi-layer piezoelectric actuator measured after long-term operation of $1 \times 10^{10}$ cycles following continuous operation of $1 \times 10^9$ cycles showed significant decrease in the displacement after long-term operation of $1 \times 10^{10}$ cycles over the displacement after continuous operation of $1 \times 10^9$ cycles, indicating an increasing degree of deterioration and difficulty in continuously operating the multi-layer piezoelectric actuator.

With the change in dimension of the piezoelectric layer more than 5% after continuous operation, displacement of the multi-layer piezoelectric actuator measured after long-term operation of $1 \times 10^{10}$ cycles following continuous operation of $1 \times 10^9$ cycles showed significant decrease in the displacement after long-term operation of $1 \times 10^{10}$ cycles over the displacement after continuous operation of $1 \times 10^9$ cycles, indicating an increasing degree of deterioration and difficulty in continuously operating the multi-layer piezoelectric actuator.

Samples Nos. 1 through 8 of Example 1 according to the present invention were multi-layer piezoelectric actuators having changes in displacement of the element within 5% after continuous operation, in contrast, showing an amount of displacement required for the multi-layer piezoelectric actuator without significantly decreasing the amount of displacement of the device even when operated for $1 \times 10^{10}$ cycles after continuous operation of $1 \times 10^9$ cycles, and the multi-layer piezoelectric actuator having excellent durability without thermal excursion and malfunction was made.

Similarly, samples Nos. 1 through 8 of Example 1 also had changes in resistance of the device within 5% after continuous operation, showing an amount of displacement required for the multi-layer piezoelectric actuator without significantly decreasing the amount of displacement of the device even when operated for $1 \times 10^{10}$ cycles after continuous operation of $1 \times 10^9$ cycles, and the multi-layer piezoelectric actuator having excellent durability without thermal excursion and malfunction was made.

Similarly, samples Nos. 1 through 8 of Example 1 had changes in dimension of the piezoelectric layer within 5% after continuous operation, showing an amount of displacement required for the multi-layer piezoelectric actuator without significantly decreasing the amount of displacement of the device even when operated for $1 \times 10^{10}$ cycles after continuous operation of $1 \times 10^9$ cycles, and the multi-layer piezoelectric actuator having excellent durability without thermal excursion and malfunction was made.

Example 2

In addition to the manufacturing method described above, the multi-layer piezoelectric actuator of the present invention made by controlling resistance of the device and the induction loss (tan $\delta$) of the piezoelectric material 1 to a low level, maximum change in the amount of displacement of the device, maximum change in resistance of the device and change in device temperature after continuous operation of the multi-layer piezoelectric actuator were measured. These measurements were examined against durability of the multi-layer piezoelectric actuator.

The degree of deterioration is determined as follows. The amount of displacement of the element after operating the multi-layer piezoelectric actuator for an arbitrary number of cycles (the amount of displacement after continuous operation) is measured. Then the amount of displacement of the device after operating the multi-layer piezoelectric actuator for a predetermined number of cycles (the amount of displacement after a long period of operation) is measured. The degree of deterioration is defined as the ratio of the change in the amount of displacement after a long period of operation to the amount of displacement after continuous operation. This value enables it to examine the progress of deterioration, by operating the multi-layer piezoelectric actuator, that has been operated an arbitrary number of times, further for a predetermined number of cycles.

As Comparative Example, samples were made of which changes in displacement or change in resistance of the device during continuous operation of the multi-layer piezoelectric actuator exceeded 5%.

When a DC voltage of 170 V was applied to the multi-layer piezoelectric actuators made as described above, all the multi-layer piezoelectric actuators underwent displacement of 45 $\mu$m in the direction of stacking. Operation test was conducted on the multi-layer piezoelectric actuators by applying an AC voltage varying between 0 V and +170 V at frequency of 150 Hz at room temperature to carry out continuous operation of $1 \times 10^9$ cycles. The results are shown in Table 2.

Table 2-1

| No. | Resistance of internal electrode normalized to resistance of 100% silver | Induction loss tan (%) of the piezoelectric material | Amount of displacement ($\mu$m) in initial state = A |
|---|---|---|---|
| 1 | 2 | 0.5 | 45.0 |
| 2 | 3 | 0.5 | 45.0 |
| 3 | 4 | 0.5 | 45.0 |
| 4 | 5 | 0.5 | 45.0 |
| 5 | 8 | 0.5 | 45.0 |
| 6 | 10 | 0.5 | 45.0 |
| 7 | 5 | 1.5 | 45.0 |
| *8 | 8 | 1.5 | 45.0 |
| *9 | 10 | 2.5 | 45.0 |

Table 2-2

| No. | Maximum change (%) in temperature of element during continuous operation ($1 \times 10^8$ cycles) | Maximum change (%) in resistance of element during continuous operation ($1 \times 10^8$ cycles) | Maximum displacement ($\mu$m) during continuous operation ($1 \times 10^8$ cycles) = B |
|---|---|---|---|
| 1 | 0.0 | 0.0 | 45.0 |
| 2 | 0.2 | 0.2 | 44.9 |
| 3 | 0.4 | 0.4 | 44.8 |
| 4 | 0.6 | 0.7 | 44.7 |
| 5 | 0.8 | 0.9 | 44.6 |
| 6 | 1.8 | 2.0 | 44.1 |
| 7 | 4.5 | 5.0 | 42.8 |
| *8 | 7.0 | 7.8 | 41.5 |
| *9 | 5.0 | 5.6 | 47.5 |

Table 2-3

| No. | Maximum rate of change (%) in displacement during continuous operation to initial displacement = $\mid (A-B)/A \times 100 \mid$ | Displacement ($\mu$m) during continuous operation ($1 \times 10^9$ cycles) = C | Degree of deterioratio n (%) = $\mid (B - C)/B \times 100 \mid$ |
|---|---|---|---|
| 1 | 0 | 45.0 | 0.00 |
| 2 | 0.2 | 44.9 | 0.00 |
| 3 | 0.4 | 44.7 | 0.22 |
| 4 | 0.7 | 44.6 | 0.22 |
| 5 | 0.9 | 44.4 | 0.45 |
| 6 | 2.0 | 43.7 | 0.91 |
| 7 | 5.0 | 91.9 | 1.99 |
| *8 | 7.8 | 38.0 | 8.43 |
| *9 | 5.6 | Thermal excursion occurred | - |
| In the tables described above, sample marked with * is out of the scope of the present invention. | | | |

Table 2 shows that samples Nos. 8 and 9 that were comparative examples showed maximum change in displacement more than 5% during continuous operation. As a result, displacement of the multi-layer piezoelectric actuator measured after continuous operation of $1 \times 10^9$ cycles showed significant decrease in the displacement of the device after continuous operation of $1 \times 10^9$ cycles compared to the maximum displacement of the device during continuous operation of $1 \times 10^8$ cycles, indicating an increasing degree of deterioration. Sample No. 9 experienced thermal excursion resulting in destruction of the element, making it difficult to carry out continuous operation of the multi-layer piezoelectric actuator.

With maximum change in resistance of the element more than 5% during continuous operation, displacement of the multi-layer piezoelectric actuator measured after long-term operation of $1 \times 10^9$ cycles showed significant decrease in the displacement of the device compared to the maximum displacement of the device during continuous operation of $1 \times 10^8$ cycles after continuous operation of $1 \times 10^9$ cycles, indicating an increasing degree of deterioration and difficulty in continuously operating the multi-layer piezoelectric actuator.

Samples Nos. 1 through 7 of Example 2 according to the present invention were multi-layer piezoelectric actuators having maximum changes in displacement of the device within 5% after continuous operation, showing an amount of displacement required for the multi-layer piezoelectric actuator without significantly decreasing the amount of displacement of the device even after continuous operation of $1 \times 10^9$ cycles, and the multi-layer piezoelectric actuator having excellent durability without thermal excursion and malfunction were made.

Samples Nos. 1 through 7 of Example 2, having changes in resistance of the device within 5% after continuous operation, showed amount of displacement required for the multi-layer piezoelectric actuator after continuous operation of $1 \times 10^9$ cycles, and enabled it to make the multi-layer piezoelectric actuator having excellent durability without thermal excursion and malfunction.

Example 3

Multi-layer piezoelectric actuators having the internal electrodes 2 formed from electrode materials of various compositions were made by the manufacturing method described above. Maximum change in the amount of displacement of the multi-layer piezoelectric actuator during continuous operation was measured, and relation between the composition of electrode material of the internal electrodes 2 and the degree of deterioration of the multi-layer piezoelectric actuator after continuous operation was examined.

When a DC voltage of 170 V was applied to the multi-layer piezoelectric actuators made as described above, all the multi-layer piezoelectric actuators underwent displacement of 45 $\mu$m in the direction of stacking. Operation test was conducted on the multi-layer piezoelectric actuators by applying an AC voltage varying between 0 V and +170 V at frequency of 150 Hz at room temperature to carry out continuous operation of $1 \times 10^9$ cycles. The results are shown in Table 3.

Table 3-1

| No | Pd content in metal of internal electrode (% by weight) | Ag content in metal of internal electrode (% by weight) | Cu content in metal of internal electrode (% by weight) | Ni content in metal of internal electrode (% by weight) |
|---|---|---|---|---|
| 1 | 0 | 100 | 0 | 0 |
| 2 | 0.001 | 99.999 | 0 | 0 |
| 3 | 0.01 | 99.99 | 0 | 0 |
| 4 | 0.1 | 99.9 | 0 | 0 |
| 5 | 0.5 | 99.5 | 0 | 0 |
| 6 | 1 | 99 | 0 | 0 |
| 7 | 2 | 98 | 0 | 0 |
| 8 | 4 | 95 | 1 | 0 |
| 9 | 5 | 95 | 0 | 0 |
| 10 | 8 | 92 | 0 | 0 |
| 11 | 9 | 91 | 0 | 0 |
| 12 | 9.5 | 90.5 | 0 | 0 |
| 13 | 10 | 90 | 0 | 0 |
| 14 | 15 | 85 | 0 | 0 |
| 15 | 0 | 0 | 100 | 0 |
| 16 | 0 | 0 | 99.9 | 0.1 |
| 17 | 0 | 0 | 0 | 100 |
| 18 | 20 | 80 | 0 | 0 |
| 19 | 30 | 70 | 0 | 0 |

Table 3-2

| No. | Rate of change (%) in displacement after continuous operation to initial displacement | Degree of deterioration (%) |
|---|---|---|
| 1 | Damaged by migration | - |
| 2 | 0.7 | 0.22 |
| 3 | 0.7 | 0.22 |
| 4 | 0.4 | 0.22 |
| 5 | 0.2 | 0.00 |
| 6 | 0.2 | 0.00 |
| 7 | 0 | 0.00 |
| 8 | 0 | 0.00 |
| 9 | 0 | 0.00 |
| 10 | 0 | 0.00 |
| 11 | 0.2 | 0.00 |
| 12 | 0.2 | 0.00 |

(continued)

| No. | Rate of change (%) in displacement after continuous operation to initial displacement | Degree of deterioration (%) |
|---|---|---|
| 13 | 0.4 | 0.22 |
| 14 | 0.7 | 0.22 |
| 15 | 0.2 | 0.00 |
| 16 | 0 | 0.00 |
| 17 | 0.4 | 0.22 |
| 18 | 0.9 | 0.45 |
| 19 | 0.9 | 0.45 |

As shown in Table 3, sample No. 1 comprising the internal electrode 2 formed from 100% silver underwent silver migration that damaged the multi-layer piezoelectric actuator, making it difficult to carry out continuous operation. Samples Nos. 18 and 19, comprising the internal electrode 2 containing metal composition with more than 15% by weight of VIII metal and less than 85% by weight of Ib metal, experienced increasing deterioration due to continuous operation, thus resulting in lower durability of the multi-layer piezoelectric actuator.

Samples Nos. 2 through 17 of Example 3 of the present invention, comprising the internal electrode 2 having such a metal composition that proportion M1 (% by weight) of the group VIII metal and proportion M2 (% by weight) of the group Ib metal satisfied the relations $0 < M1 \le 15$, $85 \le M2 < 100$ and $M1 + M2 = 100$, in contrast, had lower specific resistance of the internal electrode 2 so as to suppress the heat generation from the internal electrodes 2 during continuous operation, thus provided the multi-layer piezoelectric actuator showing stable amount of displacement of the device.

The present invention is not limited to Example described above, and various modifications may be made within the scope of the present invention.

Example 4

The multi-layer piezoelectric actuator of the present invention was fabricated as described below in Example 4.

First, a column-like stack was made. Piezoelectric layers were formed from lead titanate zirconate ($PbZrO_3$-$PbTiO_3$) to a thickness of 150 $\mu$m, and internal electrodes 2 were formed thereon to a thickness of 3 $\mu$m. Then 300 pieces each of the piezoelectric layers and the internal electrodes were stacked. The internal electrodes were formed from a mixed powder of metal (for example, 90Ag-10Pd) and ceramics as shown in Table 4. For the ceramic powder, PZT, $ZrO_2$, $TiO_2$, a mixture of PZT and $ZrO_2$, or a mixture of PZT and $TiO_2$ is preferably used. The materials shown in Table 4-3 were used in proportions shown in the table, in this Example. Ceramic powder consisting of column-like particles having diameter of 1.5 $\mu$m or smaller and aspect ratio of 3 or less was used. After degreasing at a temperature from 400 to 700°C, the stack was held at 850°C for 20 minutes and fired at a temperature of 1000°C to obtain the sintered material. In case the internal electrodes were made of Ni, the stack was degreased at a temperature from 400 to 700°C, held at 1050°C for 20 minutes and fired at a temperature of 1200°C to obtain the sintered material.

Then a groove measuring 50 $\mu$m in depth and 50 $\mu$m in width was formed at the end of the internal electrode located on the side face of the column-like stack in every other layer, by means of a dicing apparatus. Then 90% by volume of silver powder of flake-like particles having mean particle size of 2 $\mu$m and 10% by volume of amorphous glass powder having softening point of 640°C containing silicon as the main component having mean particle size of 2 $\mu$m were mixed, and 8 weight parts of a binder was added to 100 weight parts in total of the silver powder and the glass powder, so as to prepare the electrically conductive silver-glass paste by fully mixing the powders. The electrically conductive silver-glass paste thus prepared was screen printed onto a release film. After drying, the paste film was peeled off the release film to obtain a sheet of electrically conductive silver-glass paste. Density of the green sheet as measured by Archimedes method was 6.5 g/cm$^3$.

The sheet of the silver-glass paste was transferred onto the external electrode surface of the column-like stack and was baked at 650°C for 30 minutes, thereby forming the external electrode from the porous electrically conductive material having 3-dimensional mesh structure. Measurement of void ratio of the external electrode by means of image analysis apparatus on a photograph of a cut surface of the external electrode showed a void ratio of 40%.

Then lead wires were connected to the external electrodes, and DC electric field of 3 kV/mm was applied between the positive and negative external electrodes via the lead wires so as to apply polarization treatment for 15 minutes, thereby to complete the multi-layer piezoelectric actuator using the multi-layer piezoelectric element as shown in Fig. 1.

With a DC voltage of 170 V applied to the multi-layer piezoelectric actuators comprising the multi-layer piezoelectric element made as described above, displacements of the samples were measured, and variation in the displacement was calculated with the results shown in Table 4. Operation test was conducted on the multi-layer piezoelectric actuators by applying an AC voltage varying between 0 V and +170 V at frequency of 150 Hz at room temperature.

DC voltage of 170 V was applied to the multi-layer piezoelectric actuators comprising the multi-layer piezoelectric elements that reached $1 \times 10^9$ cycles of operation, and displacement of each sample was measured thereby to determine the change in displacement after the operation. Specifically, the amount of displacement before the operation test was divided by the amount of displacement after the operation test, and the result was multiplied by 100 thus giving a value in percentage.

Diameter and number of the pillars that penetrated the internal electrode and connected the piezoelectric layers were measured as follows.

Proportion of the pillars that had diameters in the section of junction not smaller than 50% of the maximum diameter was determined as follows. With a length of 1 mm measured in a photograph of a section of the multi-layer piezoelectric element on a region near the internal electrode 2 as shown in Fig. 2, maximum diameter A and diameter B in the section 22 of the junction between the pillars 18 and the piezoelectric layer 1 were measured for each pillar 18. Value of (B/A) $\times$ 100 was calculated from these measurements, so as to determine the ratio of diameter B in the section 22 of the junction between the pillars 18 and the piezoelectric layer 1 to the maximum diameter A for each pillar 18. Proportion by percentage of the pillars having this ratio not less than 50% to the number of pillars measured was calculated. This operation was carried out at ten points and the results are averaged. Minimum diameter of the pillar was also measured similarly to the above at 10 points.

Results of the measurements described above, materials of the internal electrodes and the difference in thermal expansion coefficient between the piezoelectric layer and the pillar are shown in Table 4.

Table 4-1

| No. | Pillar | Proportion of pillars having diameters in junction not smaller than 50% of maximum diameter | Average of minimum diameters of the pillars | Number of pillars per 1 mm |
|---|---|---|---|---|
| | - | % | μm | Pieces |
| 1 | Provided | 20 | 1 | 65 |
| 2 | Provided | 30 | 1 | 77 |
| 3 | Provided | 50 | 1 | 83 |
| 4 | Provided | 70 | 1 | 76 |
| 5 | Provided | 90 | 1 | 68 |
| 6 | Provided | 50 | 0.1 | 95 |
| 7 | Provided | 50 | 0.2 | 84 |
| 8 | Provided | 50 | 0.5 | 63 |
| 9 | Provided | 50 | 1 | 61 |
| 10 | Provided | 50 | 3 | 50 |
| 11 | Provided | 50 | 5 | 34 |
| 12 | Provided | 50 | 2 | 5 |
| 13 | Provided | 50 | 2 | 11 |
| 14 | Provided | 50 | 2 | 54 |
| 15 | Provided | 50 | 2 | 99 |
| 16 | Provided | 50 | 2 | 148 |
| 17 | Provided | 50 | 1 | 84 |
| 18 | Provided | 50 | 1 | 90 |
| 19 | Provided | 50 | 1 | 79 |

(continued)

| No. | Pillar | Proportion of pillars having diameters in junction not smaller than 50% of maximum diameter | Average of minimum diameters of the pillars | Number of pillars per 1 mm |
|---|---|---|---|---|
| 20 | Provided | 50 | 1 | 76 |
| 21 | Provided | 50 | 1 | 86 |
| 22 | Provided | 50 | 1 | 83 |
| 23 | Provided | 50 | 1 | 76 |
| 24 | Provided | 50 | 1 | 89 |
| 25 | Provided | 50 | 1 | 83 |
| 26 | None | - | - | - |

Table 4-2

| No. | Difference in thermal expansion coefficient between piezoelectric layer and pillar $\times$ 10$^{-6}$/°C | Materials of piezoelectric layer and pillar | Material of internal electrode |
|---|---|---|---|
| 1 | 0 | Same | 90Ag-10Pd |
| 2 | 0 | Same | 90Ag-10Pd |
| 3 | 0 | Same | 90Ag-10Pd |
| 4 | 0 | Same | 90Ag-10Pd |
| 5 | 0 | Same | 90Ag-10Pd |
| 6 | 0 | Same | 90Ag-10Pd |
| 7 | 0 | Same | 90Ag-10Pd |
| 8 | 0 | Same | 90Ag-10Pd |
| 9 | 0 | Same | 90Ag-10Pd |
| 10 | 0 | Same | 90Ag-10Pd |
| 11 | 0 | Same | 90Ag-10Pd |
| 12 | 0 | Same | 90Ag-10Pd |
| 13 | 0 | Same | 90Ag-10Pd |
| 14 | 0 | Same | 90Ag-10Pd |
| 15 | 0 | Same | 90Ag-10Pd |
| 16 | 0 | Same | 90Ag-10Pd |
| 17 | 2 | Different | 90Ag-10Pd |
| 18 | 5 | Different | 90Ag-10Pd |
| 19 | 6 | Different | 90Ag-10Pd |
| 20 | 0 | Same | 85Ag-15Pd |
| 21 | 0 | Same | 95Ag-5Pd |
| 22 | 0 | Same | 99Ag-1Pd |
| 23 | 0 | Same | 99.9Ag-0.1Pd |

(continued)

| No. | Difference in thermal expansion coefficient between piezoelectric layer and pillar $\times$ $10^{-6}$/°C | Materials of piezoelectric layer and pillar | Material of internal electrode |
|---|---|---|---|
| 24 | 0 | Same | 100Cu |
| 25 | 0 | Same | 100Ni |
| 26 | - | - | 70Ag-30Pd |

Table 4-3

| No. | Material of pillar | Proportion (% by weight) |
|---|---|---|
| 1 | PZT | 20 |
| 2 | PZT | 23 |
| 3 | PZT | 24 |
| 4 | PZT | 22 |
| 5 | PZT | 20 |
| 6 | PZT | 27 |
| 7 | PZT | 24 |
| 8 | PZT | 19 |
| 9 | PZT | 19 |
| 10 | PZT | 16 |
| 11 | PZT | 12 |
| 12 | PZT | 5 |
| 13 | PZT | 6 |
| 14 | PZT | 17 |
| 15 | PZT | 28 |
| 16 | PZT | 40 |
| 17 | PZT20% + ZrO$_2$80% | 24 |
| 18 | PZT50% + ZrO$_2$50% | 26 |
| 19 | PZT50% + TiO$_2$50% | 23 |
| 20 | PZT | 22 |
| 21 | PZT | 25 |
| 22 | PZT | 24 |
| 23 | PZT | 22 |
| 24 | PZT | 26 |
| 25 | PZT | 24 |
| 26 | - | - |

Table 4-4

| No. | Variation (%) in displacement | Ratio of change (%) in displacement after continuous durability test |
|---|---|---|
| 1 | 10 | 5 |
| 2 | 8 | 4 |
| 3 | 5 | 2.5 |
| 4 | 5 | 1 |
| 5 | 4 | 0.5 |
| 6 | 8 | 4 |
| 7 | 7 | 4 |
| 8 | 6 | 3 |
| 9 | 5.5 | 2.5 |
| 10 | 4 | 1 |
| 11 | 3 | 0.5 |
| 12 | 7 | 4 |
| 13 | 6 | 3 |
| 14 | 4 | 2 |
| 15 | 3 | 0.5 |
| 16 | 2 | 0.5 |
| 17 | 3 | 0.5 |
| 18 | 3 | 0.5 |
| 19 | 3 | 0.5 |
| 20 | 3 | 1 |
| 21 | 3 | 0.5 |
| 22 | 3 | 0.5 |
| 23 | 3 | 0.5 |
| 24 | 3 | 0.5 |
| 25 | 3 | 0.5 |
| 26 | 20 | 10 |

Samples Nos. 1 through 25 of Example 4 of the present invention having the pillars that penetrated the internal electrode and connected the piezoelectric layers via the internal electrode showed variation in the initial displacement not greater than 10%, smaller than that of Comparative Example (No. 26). Change in displacement after the continuous durability test was also small, within 5%, thus showing higher reliability and higher durability than the Comparative Example.
Samples Nos. 2 through 25 of Example 4 where 30% or more of the pillars had diameter in the junction not smaller than 50% of the maximum diameter, in particular, showed variation in the initial displacement of 8% or less and even smaller change in displacement after the continuous durability test, within 4%, thus showing even higher reliability and higher durability.
Samples Nos. 3 through 5 and 7 through 25 of Example 4 where 50% or more of the pillars had diameter in the junction not smaller than 50% of the maximum diameter and that mean value of minimum diameters of the pillars was 0.2 $\mu$m, in particular, showed even smaller variation in the initial displacement of 7% or less, thus showing even higher reliability.
Sample No. 26 that was out of the scope of the present invention and was not provided with the pillars, in contrast, showed large variation of 20% in the initial displacement and the displacement after continuous durability test also showed large variation of 10%, indicating lower characteristics than the sample of the present invention in reliability and durability.

Example 5

The multi-layer piezoelectric actuator of the present invention was made in Example 5 as described below. First, a calcined powder of a piezoelectric ceramic material constituted from lead titanate zirconate ($PbZrO_3$-$PbTiO_3$), a binder and a plasticizer were mixed to form a slurry. The slurry was formed into ceramic green sheets having thickness of 150 $\mu$m that would become the piezoelectric layers 1 by doctor blade process.

The ceramic green sheets were coated on one side thereof with a paste selected from among an electrically conductive paste consisting of silver-palladium alloy with a binder added thereto, an electrically conductive paste consisting of Ag with a binder added thereto, an electrically conductive paste consisting of Cu with a binder added thereto and an electrically conductive paste consisting of Ni with a binder added thereto by screen printing to a thickness of 3 $\mu$m, thus preparing 300 sheets with the electrically conductive paste printed thereon, to be used in forming the stack. Other green sheets were prepared to form the protective section. 30 sheets for the protective section, 300 sheets for the stack and 30 sheets for the protective section were stacked successively and pressed, before being fired at 1000°C.

Then a groove measuring 50 $\mu$m in depth and 50 $\mu$m in width was formed at the end of the internal electrode located on the side face of the stack in every other layer, by means of a dicing apparatus.

Then 90% by volume of silver powder of flake-like particles having mean particle size of 2 $\mu$m and 10% by volume of amorphous glass powder having softening point of 640°C containing silicon as the main component having mean particle size of 2 $\mu$m were mixed, and 8 weight parts of a binder was added to 100 weight parts in total of the silver powder and the glass powder, so as to prepare the electrically conductive silver-glass paste by fully mixing the powders. The electrically conductive silver-glass paste thus prepared was screen printed onto a release film. After drying, the paste film was peeled off the release film to obtain a sheet of electrically conductive silver-glass paste. Density of the green sheet as measured by Archimedes method was 6.5 g/cm$^3$.

The sheet of the silver-glass paste was transferred onto the external electrode surface of the stack and was baked at 650°C for 30 minutes, thereby forming the external electrode from the porous electrically conductive material having 3-dimensional mesh structure. Measurement of void ratio of the external electrode by means of image analysis apparatus on a photograph of a cut surface of the external electrode showed a void ratio of 40%.

Then lead wires were connected to the external electrodes, and DC electric field of 3 kV/mm was applied to the positive and negative external electrodes via the lead wires so as to apply polarization treatment for 15 minutes, thereby to complete the multi-layer piezoelectric actuator using the multi-layer piezoelectric element as shown in Fig. 5. With a DC voltage of 170 V applied to the multi-layer piezoelectric element made as described above, displacements of 45 $\mu$m in the direction of stacking was observed. Operation test was conducted on the multi-layer piezoelectric elements by applying an AC voltage varying between 0 V and +170 V at frequency of 150 Hz at room temperature.

Failure rate of the multi-layer piezoelectric element was determined as the number of samples that failed before undergoing $1 \times 10^9$ cycles of continuous operation.

The results are shown in Table 5. Thickness of the piezoelectric layer of the protective section was varied from 50 to 200 $\mu$m as shown in Table 5, and the dummy layer was formed from one of silver-palladium alloy, silver, copper and nickel. The dummy layer contained PZT as an inorganic composition.

Table 5-1

| No. | A/B | Dummy layer |
|-----|-----|-------------|
| 1 | 0.04 | 99.99Ag-0.01Pd |
| 2 | 0.04 | 99Ag-1Pd |
| 3 | 0.04 | 95Ag-5Pd |
| 4 | 0.04 | 90Ag-10Pd |
| 5 | 0.04 | 70Ag-30Pd |
| 6 | 0.04 | 50Ag-50Pd |
| 7 | 0.005 | 90Ag-10Pd |
| 8 | 0.01 | 90Ag-10Pd |
| 9 | 0.02 | 90Ag-10Pd |
| 10 | 0.03 | 90Ag-10Pd |

(continued)

| No. | A/B | Dummy layer |
|-----|------|-------------|
| 11 | 0.05 | 90Ag-10Pd |
| 12 | 0.06 | 90Ag-10Pd |
| 13 | 0.07 | 90Ag-10Pd |
| 14 | 0.08 | 90Ag-10Pd |
| 15 | 0.09 | 90Ag-10Pd |
| 16 | 0.02 | 95Ag-5Pd |
| 17 | 0.08 | 95Ag-5Pd |
| 18 | 0.04 | 90Ag-10Pd |
| 19 | 0.04 | 90Ag-10Pd |
| 20 | 0.04 | 90Ag-10Pd |
| 21 | 0.04 | 90Ag-10Pd |
| 22 | 0.04 | 90Ag-10Pd |
| 23 | 0.04 | 90Ag-10Pd |
| 24 | 0.09 | 90Ag-10Pd |
| 25 | 0.04 | 90Ag-10Pd |
| 26 | 0.04 | 90Ag-10Pd |
| 27 | 0.04 | 100Ag |
| 28 | 0.09 | 100Cu |
| 29 | 0.04 | 100Ni |
| 30 | 0.04 | Glass |

Table 5-2

| No. | Internal electrode | Thickness (μm) of piezoelectric layer | Inorganic composition content (% by weight) in dummy layer | Failure rate (%) after continuous durability test |
|-----|--------------------|--------------------------------------|-----------------------------------------------------------|---------------------------------------------------|
| 1 | Same as the dummy layer | 100 | 20 | 0.3 |
| 2 | Same as the dummy layer | 100 | 20 | 0.1 |
| 3 | Same as the dummy layer | 100 | 20 | 0.2 |
| 4 | Same as the dummy layer | 100 | 20 | 0.2 |
| 5 | Same as the dummy layer | 100 | 20 | 0.4 |
| 6 | Same as the dummy layer | 100 | 20 | 0.8 |
| 7 | Same as the dummy layer | 100 | 20 | 3 |

(continued)

| No. | Internal electrode | Thickness ($\mu$m) of piezoelectric layer | Inorganic composition content (% by weight) in dummy layer | Failure rate (%) after continuous durability test |
|---|---|---|---|---|
| 8 | Same as the dummy layer | 100 | 20 | 2 |
| 9 | Same as the dummy layer | 100 | 20 | 1 |
| 10 | Same as the dummy layer | 100 | 20 | 0.5 |
| 11 | Same as the dummy layer | 100 | 20 | 0.4 |
| 12 | Same as the dummy layer | 100 | 20 | 0.5 |
| 13 | Same as the dummy layer | 100 | 20 | 0.8 |
| 14 | Same as the dummy layer | 100 | 20 | 2 |
| 15 | Same as the dummy layer | 100 | 20 | 3.5 |
| 16 | Same as the dummy layer | 100 | 20 | 0.8 |
| 17 | Same as the dummy layer | 100 | 20 | 1.8 |
| 18 | Same as the dummy layer | 50 | 20 | 0.2 |
| 19 | Same as the dummy layer | 70 | 20 | 0.2 |
| 20 | Same as the dummy layer | 150 | 20 | 0.3 |
| 21 | Same as the dummy layer | 200 | 20 | 0.2 |
| 22 | Same as the dummy layer | 100 | 2 | 0.4 |
| 23 | Same as the dummy layer | 100 | 10 | 0.2 |
| 24 | Same as the dummy layer | 100 | 30 | 0.2 |
| 25 | Same as the dummy layer | 100 | 40 | 0.4 |
| 26 | 70Ag-30Pd | 100 | 20 | 1 |
| 27 | Same as the dummy layer | 100 | 20 | 0.2 |
| 28 | Same as the dummy layer | 100 | 20 | 0.2 |
| 29 | Same as the dummy layer | 100 | 20 | 0.2 |

(continued)

| No. | Internal electrode | Thickness (μm) of piezoelectric layer | Inorganic composition content (% by weight) in dummy layer | Failure rate (%) after continuous durability test |
|---|---|---|---|---|
| 30 | 70Ag-30Pd | 100 | 20 | 1 |

Table 5 shows that samples Nos. 1 through 6, 8 through 14 and 16 through 30 of Example 5 within the scope of the present invention, where ratio A/B of the minimum distance A between the periphery of the dummy layer and the side face of the protective section to the width B of the protective section in the section perpendicular to the direction of stacking was in a range from 0.01 to 0.08, showed failure rate of 2% or less after the continuous durability test, lower than those of comparative example (Nos. 7 and 15), thus proving excellent durability.

Samples Nos. 1 through 6, 9 through 13, 16 and 18 through 30 of Example 5 where A/B was in a range from 0.02 to 0.07, in particular, showed failure rate of 1% or lower after the continuous durability test, thus proving excellent durability.

Samples Nos. 1 through 6, 10 through 13, 16, 18 through 25 and 27 through 29 of Example 5 where A/B was in a range from 0.02 to 0.07, the dummy layer contained a metal, the internal electrodes were made of the same material as that of the dummy layer, thickness of the piezoelectric layer was 50 μm or more and the dummy layer contained 2% by weight or more of an inorganic composition, in particular, showed failure rate of 0.8% or lower after the continuous durability test, thus proving even better durability.

Sample No. 7 where ratio A/B was lower than 0.01 and sample No. 15 where ratio A/B was higher than 0.08, that were out of the scope of the present invention, showed 3% or worse failure rate after the durability test, thus proving durability lower than that of the present invention.

INDUSTRIAL APPLICABILITY

The multi-layer piezoelectric element of the present invention can be applied to piezoelectric transducer. The multi-layer piezoelectric element of the present invention can also be applied to a multi-layer piezoelectric actuator used in an injection apparatus for injecting automobile fuel or ink of an ink jet printer, or a drive unit used in precision positioning device or vibration preventing device for an optical apparatus. The multi-layer piezoelectric element can also be used as a sensor element mounted in combustion pressure sensor, knocking sensor, acceleration sensor, load sensor, ultrasound sensor, pressure sensor, yaw rate sensor or the like, or used as a circuit component mounted in piezoelectric gyro, piezoelectric switch, piezoelectric transducer, piezoelectric breaker or the like.

**Claims**

1.  A multi-layer piezoelectric element comprising:

    a stack formed by stacking piezoelectric layers and internal electrodes alternately one on another; and
    external electrodes constituted from the powders of electrically conductive material and glass, and formed on a first side face and on a second side face of the stack, one of the adjacent internal electrodes being connected to the external electrode formed on the first side face and the other internal electrode being connected to the external electrode formed on the second side face, **characterized in that**
    a ratio of change in the amount of displacement of the element after undergoing continuous operation of 1 x $10^9$ cycles or more to an initial device displacement before undergoing continuous operation is not larger than 5%, wherein the powders of electrically conductive material and the glass are bonded with each other so as to form a porous electrical conductor having a 3-dimensional mesh configuration.

2.  The multi-layer piezoelectric element according to claim 1, wherein the glass is amorphous glass.

3.  The multi-layer piezoelectric element according to claim 1,
    wherein further comprising a glass-rich layer formed on the surface of the external electrodes on the side of the surface of the piezoelectric layers.

4.  The multi-layer piezoelectric element according to claim 1,
    wherein further comprising an electrical conductivity assisting member formed from an electrically conductive adhesive, including a metal mesh or a mesh-like metal sheet embedded in, provided on the external surface of the external electodes.

**5.** The multi-layer piezoelectric element according to claim 4,
wherein the electrically conductive adhesive contains electrically conductive particles dispersed in,
wherein the electrically conductive particles are non-spherical particles having such shapes as flakes or acicular particles.

**6.** The multi-layer piezoelectric element according to claim 1,
wherein pillars are provided to penetrate the internal electrode and connect the piezoelectric layers that oppose each other via the internal electrode.

**7.** The multi-layer piezoelectric element according to claim 6,
wherein a difference in thermal expansion coefficient between the pillars and a piezoelectric material constitutes the piezoelectric layers is $3 \times 10^{-5}$ / °C or less.

**8.** The multi-layer piezoelectric element according to claim 6,
wherein the pillars are formed from the same material of the piezoelectric layers.

**9.** The multi-layer piezoelectric element as in one of claims 1-8,
wherein the stack includes inactive protective layers formed by alternately stacking the piezoelectric layers and dummy layers on the top and bottom thereof, and the ratio A/B of minimum distance A between the periphery of the dummy layer and the side face of the inactive protective layers to width B of the inactive protective layer is in a range from 0.01 to 0.08.

**10.** The multi-layer piezoelectric element according to claim 9,
wherein the dummy layer contains a metal.

**11.** The multi-layer piezoelectric element according to claims 9 or 10,
wherein the dummy layer is formed from the same material of the internal electrode.

**12.** The multi-layer piezoelectric element as in one of claims 9-11,
wherein the piezoelectric layer has a thickness not less than 50 $\mu$m.

**13.** The multi-layer piezoelectric element as in one of claims 9-12,
wherein the dummy layer contains an inorganic composition selected from a group consisting of a metal oxide, a nitride and a carbide.

**14.** The multi-layer piezoelectric element as in one of claims 9-13,
wherein the dummy layer contains 2% by weight or more of an inorganic composition.

**15.** The multi-layer piezoelectric element according to claim 9,
wherein the dummy layers contains glass.

**16.** The multi-layer piezoelectric element according to claim 9,
wherein the dummy layers contains an inorganic composition crosslinking between the piezoelectric layers.

**17.** The multi-layer piezoelectric element as in one of claims 1-16,
wherein a first groove is formed between the end of the other internal electrode and the external electrode on the first side face, with the first groove being filled with a first insulating material and a second groove is formed between the end of the one internal electrode and the external electrode on the second side face, with the second groove being filled with a second insulating material, the first and second insulating materials having Young's modulus lower than that of the piezoelectric layer.

**18.** The multi-layer piezoelectric element as in one of claims 1-17,
wherein the internal electrode includes voids and the voids occupy 5 to 70% of cross sectional area of the internal electrode.

**Patentansprüche**

1. Mehrschichtiges piezoelektrisches Element, umfassend:

   einen Stapel, gebildet durch Stapeln piezoelektrischer Schichten und Innenelektroden abwechselnd eine auf die andere; und

   Außenelektroden erzeugt von dem Puder von elektrisch leitendem Material und Glas, und gebildet auf einer ersten Seitenfläche und auf einer zweiten Seitenfläche des Stapels, wobei eine der angrenzenden Innenelektroden zu der Außenelektrode verbunden ist, die auf der ersten Seitenfläche gebildet ist und die andere Innenelektrode verbunden ist zu der Außenelektrode, die auf der zweiten Seitenfläche gebildet ist, **dadurch gekennzeichnet, dass**

   ein Verhältnis der Änderung im Wert der Verschiebung des Elements nach Durchlaufen eines Dauerbetriebs von 1 x 10$^9$ Zyklen oder mehr zu einer Anfangsbauelement-Verschiebung vor einem Durchlaufen des Dauerbetriebs, nicht größer als 5% ist,

   wobei der Puder von elektrisch leitendem Material und dem Glas miteinander gebunden sind, um einen porösen elektrischen Leiter mit einer dreidimensionalen Netzkonfiguration zu bilden.

2. Mehrschichtiges piezoelektrisches Element nach Anspruch 1, wobei das Glas ein amorphes Glas ist.

3. Mehrschichtiges piezoelektrisches Element nach Anspruch 1,
   wobei ferner umfassend eine glasreiche Schicht, die auf der Oberfläche der Außenelektroden auf der Seite der Oberfläche der piezoelektrischen Schichten gebildet ist.

4. Mehrschichtiges piezoelektrisches Element nach Anspruch 1,
   wobei ferner umfassend ein die elektrische Leitfähigkeit unterstützendes Glied, das aus einem elektrisch leitfähigen Adhäsiv gebildet ist, beinhaltend ein Metallnetz oder einen netzartigen Metallbogen, der darin eingebettet ist, bereitgestellt auf der Außenoberfläche der Außenelektroden.

5. Mehrschichtiges piezoelektrisches Element nach Anspruch 4,
   wobei das elektrisch leitfähige Adhäsiv elektrisch leitfähige Partikel beinhaltet, die darin verteilt sind,
   wobei die elektrisch leitfähigen Artikel nichtsphärische Partikel sind, die Formen wie Flocken oder nadelförmige Partikel aufweisen.

6. Mehrschichtiges piezoelektrisches Element nach Anspruch 1,
   wobei Pfeiler bereitgestellt werden, um die Innenelektrode zu penetrieren und die piezoelektrischen Schichten, die einander gegenüberstehen, über die Innenelektrode zu verbinden.

7. Mehrschichtiges piezoelektrisches Element nach Anspruch 6,
   wobei ein Unterschied den im wärmeausdehnungskoeffizient zwischen den Pfeilern und einem piezoelektrischen Material, das die piezoelektrischen Schichten darstellt, 3 x 10$^{-5}$/°C oder weniger ist.

8. Mehrschichtiges piezoelektrisches Element nach Anspruch 6,
   wobei die Pfeiler aus demselben Material wie die piezoelektrischen Schichten gebildet sind.

9. Mehrschichtiges piezoelektrisches Element nach einem der Ansprüche 1 bis 8,
   wobei der Stapel inaktive schützende Schichten beinhaltet, die gebildet sind durch wechselndes Stapeln der piezoelektrischen Schichten und Attrappenschichten auf der Ober- und Unterseite davon, und, wobei das Verhältnis A/B der Minimaldistanz A zwischen der Umgebung der Attrappenschicht und der Seitenfläche der inaktiven schützenden Schichten zur Breite B der inaktiven schützenden Schichten im Bereich von 0.01 bis 0.08 ist.

10. Mehrschichtiges piezoelektrisches Element nach Anspruch 9,
    wobei die Attrappenschicht ein Metall beinhaltet.

11. Mehrschichtiges piezoelektrisches Element nach Anspruch 9 oder 10,
    wobei die Attrappenschicht aus demselben Material wie die Innenelektrode gebildet ist.

12. Mehrschichtiges piezoelektrisches Element nach einem der Ansprüche 9 bis 11,
    wobei die piezoelektrische Schicht eine Dicke von nicht weniger als 50 μm aufweist.

**13.** Mehrschichtiges piezoelektrisches Element nach einem der Ansprüche 9 bis 12, wobei die Attrappenschicht eine anorganische Zusammensetzung beinhaltet, ausgewählt aus einer Gruppe bestehend aus Metalloxid, einem Nitrid und einem Karbid.

**14.** Mehrschichtiges piezoelektrisches Element nach einem der Ansprüche 9 bis 13, wobei die Attrappenschicht 2% des Gewichts oder mehr einer anorganischen Zusammensetzung beinhaltet.

**15.** Mehrschichtiges piezoelektrisches Element nach Anspruch 9, wobei die Attrappenschichten Glas beinhalten.

**16.** Mehrschichtiges piezoelektrisches Element nach Anspruch 9, wobei die Attrappenschichten eine anorganische Zusammensetzung beinhalten, die zwischen den piezoelektrischen Schichten verbinden.

**17.** Mehrschichtiges piezoelektrisches Element nach einem der Ansprüche 1 bis 16, wobei eine erste Kerbe gebildet ist zwischen dem Ende der anderen Innenelektrode und der Außenelektrode auf der ersten Seitenfläche, wobei die erste Kerbe mit einem ersten isolierenden Material gefüllt ist und eine zweite Kerbe gebildet wird zwischen dem Ende der einen Innenelektrode und der Außenelektrode auf der zweiten Seitenfläche, wobei die zweite Kerbe gefüllt ist mit einem zweiten isolierenden Material, wobei das erste und zweite isolierende Material ein Elastizitätsmodul geringer als das der piezoelektrischen Schicht aufweist.

**18.** Mehrschichtiges piezoelektrisches Element nach einem der Ansprüche 1 bis 17, wobei die Innenelektrode Hohlräume beinhaltet und die Hohlräume 5 - 70% einer Querschnittsfläche der Innenelektrode abdecken.

## Revendications

**1.** Élément piézoélectrique multicouche comprenant :

une pile formée en empilant des couches piézoélectriques et des électrodes internes alternativement les unes sur les autres ; et
des électrodes externes constituées à partir de poudres de matériau conducteur d'électricité et de verre, et formées sur une première face latérale et sur une seconde face latérale de la pile, l'une des électrodes internes adjacentes étant connectée à l'électrode externe formée sur la première face latérale et l'autre électrode interne étant connectée à l'électrode externe formée sur la seconde face latérale, **caractérisé en ce que :**

un rapport de variation de quantité de déplacement de l'élément après un fonctionnement continu de $1 \times 10^9$ cycles ou plus sur un déplacement du dispositif initial avant le fonctionnement continu, n'est pas supérieur à 5 %,
dans lequel les poudres de matériau conducteur d'électricité et de verre sont liées les unes aux autres de façon à former un conducteur électrique poreux qui présente une configuration de maille tridimensionnelle.

**2.** Élément piézoélectrique multicouche selon la revendication 1, dans lequel le verre est un verre amorphe.

**3.** Élément piézoélectrique multicouche selon la revendication 1, comprenant en outre une couche riche en verre formée sur la surface des électrodes externes sur le côté de la surface des couches piézoélectriques.

**4.** Élément piézoélectrique multicouche selon la revendication 1, comprenant en outre un élément qui facilite la conductivité électrique formé à partir d'un adhésif conducteur de manière électrique, comprenant une maille métallique ou une feuille métallique similaire à une maille incorporée à l'intérieur, disposé sur la surface extérieure des électrodes externes.

**5.** Élément piézoélectrique multicouche selon la revendication 4, dans lequel l'adhésif conducteur d'électricité contient des particules conductrices d'électricité dispersées à l'intérieur, dans lequel les particules conductrices d'électricité sont des particules non sphériques qui présentent des formes similaires à des flocons ou à des particules en forme de fines aiguilles.

**6.** Élément piézoélectrique multicouche selon la revendication 1,
dans lequel sont fournis des piliers qui pénètrent dans l'électrode interne et connectent les couches piézoélectriques qui s'opposent les unes les autres par l'intermédiaire de l'électrode interne.

**7.** Élément piézoélectrique multicouche selon la revendication 6,
dans lequel une différence du coefficient de dilatation thermique entre les piliers et un matériau piézoélectrique qui constitue les couches piézoélectriques, est égal ou inférieur à $3 \times 10^{-5}$ / °C.

**8.** Élément piézoélectrique multicouche selon la revendication 6,
dans lequel les piliers sont formés à partir du même matériau que celui des couches piézoélectriques.

**9.** Élément piézoélectrique multicouche selon l'une quelconque des revendications 1 à 8,
dans lequel la pile comprend des couches protectrices inactives formées en empilant alternativement les couches piézoélectriques et des couches fictives en haut et en bas de celle-ci, et le rapport A / B de la distance minimum A entre la périphérie de la couche fictive et la face latérale des couches protectrices inactives sur la largeur B de la couche protectrice inactive se situe dans une plage comprise entre 0,01 et 0,08.

**10.** Élément piézoélectrique multicouche selon la revendication 9,
dans lequel la couche fictive contient un métal.

**11.** Élément piézoélectrique multicouche selon la revendication 9 ou la revendication 10,
dans lequel la couche fictive est formée à partir du même matériau que celui de l'électrode interne.

**12.** Élément piézoélectrique multicouche selon l'une quelconque des revendications 9 à 11,
dans lequel la couche piézoélectrique présente une épaisseur qui n'est pas inférieure à 50 $\mu$m.

**13.** Élément piézoélectrique multicouche selon l'une quelconque des revendications 9 à 12,
dans lequel la couche fictive contient une composition inorganique choisie parmi le groupe constitué par un oxyde, un nitrure et un carbure de métal.

**14.** Élément piézoélectrique multicouche selon l'une quelconque des revendications 9 à 13,
dans lequel la couche fictive contient 2 % en poids ou plus d'une composition inorganique.

**15.** Élément piézoélectrique multicouche selon la revendication 9,
dans lequel les couches fictives contiennent du verre.

**16.** Élément piézoélectrique multicouche selon la revendication 9,
dans lequel les couches fictives contiennent une réticulation de composition inorganique entre les couches piézoélectriques.

**17.** Élément piézoélectrique multicouche selon l'une quelconque des revendications 1 à 16,
dans lequel une première rainure est formée entre l'extrémité de l'autre électrode interne et l'électrode externe sur la première face latérale, la première rainure étant remplie avec un premier matériau isolant, et une seconde rainure est formée entre l'extrémité de l'électrode interne et l'électrode externe sur la seconde face latérale, la seconde rainure étant remplie avec un second matériau isolant, les premier et second matériaux isolants présentant un module de Young inférieur à celui de la couche piézoélectrique.

**18.** Élément piézoélectrique multicouche selon l'une quelconque des revendications 1 à 17,
dans lequel l'électrode interne comprend des vides et les vides occupent entre 5 % et 70 % de la section transversale de l'électrode interne.

## Fig. 1A

## Fig. 1B

## Fig. 2A

## Fig. 2B

## Fig. 3

## Fig. 4A

## Fig. 4B

## Fig. 5A

*Fig. 5B*

*Fig. 6*

*Fig. 7*

*Fig. 8*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 61133715 A
- JP 1130568 A
- JP 4299588 A
- JP 9270540 A
- US 6414417 B
- US 2002158552 A